# EUROPEAN PATENT SPECIFICATION

(11) **EP 4 586 048 B1**
(45) Date of publication and mention of the grant of the patent: **28.10.2026**
(21) Application number: 23877536.5
(22) Date of filing: 19.09.2023
(51) Int. Cl.: G06F 1/16, H01F 7/00, H04M 1/02, F16C 11/04

(54) **ELECTRONIC DEVICE COMPRISING HINGE APPARATUS**
ELEKTRONISCHE VORRICHTUNG MIT SCHARNIERVORRICHTUNG
DISPOSITIF ÉLECTRONIQUE COMPRENANT UN APPAREIL À CHARNIÈRE

(30) Priority: 11.10.2022 KR 20220129785; 21.10.2022 KR 20220136386
(43) Date of publication of application: 16.07.2025
(73) Proprietor: Samsung Electronics Co., Ltd., Suwon-si, Gyeonggi-do 16677 (KR)
(72) Inventor: JI, Kyungjun, Suwon-si, Gyeonggi-do 16677 (KR); SON, Kwonho, Suwon-si, Gyeonggi-do 16677 (KR)
(74) Representative: Gulde & Partner
(86) International application number: PCT/KR2023/014191
(87) International publication number: WO 2024/080608

(56) References cited:
- WO-A1-2022/108095
- WO-A1-2022/119249
- WO-A1-2022/154233
- CN-A- 113 282 136
- KR-A- 20190 079 033
- US-A1- 2018 329 462
- US-A1- 2022 100 239
- US-A1- 2022 264 756

## Description

### [Technical Field]

Various embodiments of the disclosure relate to an electronic device including a hinge device.

### [Background Art]

As the functional gap between electronic devices from each manufacturer has markedly decreased, electronic devices are gradually becoming slimmer in order to meet consumers' purchasing needs, and are being improved to increase the rigidity of the electronic devices, strengthen design aspects of the electronic devices, and differentiate the functional elements of the electronic devices. Electronic devices are gradually evolving from a uniform rectangular shape to diverse shapes. For example, electronic devices may have a transformable structure that is convenient to carry and enables use of a large screen display when used. As part of such electronic devices, foldable-type electronic devices are continuously being released, and ensuring operational reliability for folding actions may be required.

### [Disclosure of Invention]

### [Technical Problem]

An electronic device may include a foldable electronic device having a first housing, a second housing foldably connected to the first housing via a hinge device (e.g., a hinge module, a hinge structure, or a hinge assembly). The first housing and the second housing are structurally coupled through the hinge device, ensuring operational reliability in a folded state and/or an unfolded state. The foldable electronic device allows the first housing to rotate relative to the second housing within a range of 0 to 360 degrees via the hinge device, enabling operation in an in-folding and/or out-folding manner. The foldable electronic device may include a flexible display disposed across the first housing and the second housing in an open state of 180 degrees.

The hinge device may include a pair of arms connected to the first housing and the second housing and having a cam structure, hinge cams including another cam structure arranged on the same rotational axis as the pair of arms and arranged to face the cam structure provided on the pair of arms, and multiple coil springs that bias the hinge cams toward the pair of arms, thereby providing a biasing force for cam coupling. For example, the folding and unfolding operations of the first and second housings may allow the pair of arms to rotate together, generating friction through the cam coupling structure of the hinge cams, which are cam-coupled by the biasing force of the coil springs. This cam coupling structure may provide a free-stop function, allowing the first and second housings to stop at a predetermined angle during the folding and unfolding operations, or deliver a continuous biasing force to facilitate operation in the folding or unfolding direction based on a predetermined inflection angle.

However, the coil springs are arranged with a predetermined length to bias the hinge cams, which imposes a limit to the reduction in the size of the hinge device and may run counter to the trend toward slimmer electronic devices. In addition, because the cam structures of the arms and the hinge cams make asymmetrical contact, eccentricity may occur, and this eccentricity may cause buckling of the coil springs, leading to a torque reduction of the housings or an error in the detent section during operation.

Various embodiments of the disclosure may provide an electronic device that includes a hinge device capable of contributing to the slimming of the electronic device.

Various embodiments may also provide an electronic device that includes a hinge device capable of ensuring operational reliability even during continuous folding operations.

However, the problems that the disclosure seeks to solve are not limited to the aforementioned problems, and may be expanded in various ways without departing from the scope of the disclosure.

### [Solution to Problem]

The invention is set out in the appended claims. The implementations described below are not all claimed, they are included to help understanding the context of the invention. While the description often refers of embodiments, the embodiments of the invention are those which comprise at least all the features of an independent claim. Any embodiment which does not fall within the scope of the claims does not form part of the invention, but is rather included as an illustrative example that is useful for understanding the invention. According to the present invention, claim 1 includes a first housing, a second housing, and at least one hinge device that connects the first housing and the second housing to be rotatable relative to each other around a folding axis. The at least one hinge device includes a first arm connected to the first housing and arranged to be rotatable around a first rotation axis parallel to the folding axis, the first arm including first and second cam structures spaced apart from each other to define a first cam accommodation space, a second arm connected to the second housing and arranged to be rotatable around a second rotation axis parallel to the folding axis, the second arm including third and fourth cam structures spaced apart from each other to define a second cam accommodation space, a first hinge cam arranged to be movable in a direction parallel to the folding axis, the first hinge cam including fifth and sixth cam structures cam-coupled with the first and third cam structures, respectively, in the first and second cam accommodation spaces, a second hinge cam disposed adjacent to the first hinge cam and arranged to be movable in a direction parallel to the folding axis, the second hinge cam including seventh and eighth cam structures cam-coupled with the second and fourth cam structures, respectively, in the first and second cam accommodation spaces, a first magnet arranged on the first hinge cam, and a second magnet arranged on the second hinge cam to react with the magnetic force of the first magnet.

According to various embodiments, an electronic device may include a first housing, a second housing, at least one hinge assembly connecting the first housing and the second housing to be rotatable with respect to each other around a folding axis, and a flexible display disposed to be supported by the first housing and the second housing. The at least one hinge device may include a first arm connected to the first housing and arranged to be rotatable around a first rotation axis parallel to the folding axis, the first arm including a first cam structure, a second arm connected to the second housing and arranged to be rotatable around a second rotation axis parallel to the folding axis, the second arm including a second cam structure, a hinge cam arranged to be movable in a direction parallel to the folding axis, the hinge cam including third and fourth cam structures cam-coupled with the first and second cam structures, respectively, a support structure disposed adjacent to the hinge cam, a first magnet arranged on the hinge cam, and a second magnet arranged on the support structure to react with the magnetic force of the first magnet.

According to various embodiments, a hinge device, which foldably connects a first housing and a second housing, may include a first arm connected to the first housing and arranged to be rotatable around a first rotation axis parallel to the folding axis, the first arm including first and second cam structures to define a first cam accommodation space, a second arm connected to the second housing and arranged to be rotatable around a second rotation axis parallel to the folding axis, the second arm including third and fourth cam structures to define a second cam accommodation space, a first hinge cam arranged to be movable in a direction parallel to the folding axis, the first hinge cam including fifth and sixth cam structures cam-coupled with the first and third cam structures, respectively, in the first and second cam accommodation spaces, a second hinge cam disposed adjacent to the first hinge cam and arranged to be movable in a direction parallel to the folding axis, the second hinge cam including seventh and eighth cam structures cam-coupled with the second and fourth cam structures, respectively, in the first and second cam accommodation spaces, a first magnet arranged on the first hinge cam, and a second magnet disposed at a position reacting to the magnetic force of the first magnet such that a repulsive force acts against the first magnet.

### [Advantageous Effects of Invention]

A hinge device according to exemplary embodiments of the disclosure may contribute to the slimming and improved operational reliability of an electronic device by providing the biasing force between a pair of hinge cams arranged to face a pair of arms through the repulsive force of a pair of magnets with identical polarities facing each other.

In addition, various other effects identified directly or indirectly through this document may be provided.

The effects that are capable of being obtained by the disclosure are not limited to those described above, and other effects not described above may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1A is a plan view illustrating the front surface an electronic device according to various embodiments in a flat or unfolded state.
FIG. 1B is a plan view illustrating the rear surface of the electronic device according to various embodiments of the disclosure in the unfolded state.
FIG. 2A is a view illustrating the front surface of the electronic device according to various embodiments of the disclosure in the folded state.
FIG. 2B is a view illustrating the rear surface of the electronic device according to various embodiments of the disclosure in the folded state.
FIG. 3 is an exploded perspective view of the electronic device according to various embodiments of the disclosure.
FIG. 4 is an exploded perspective view of a hinge device according to various embodiments of the disclosure.
FIG. 5A is an exploded perspective view of a hinge device illustrating a state in which hinge cams and arms according to various embodiments of the disclosure are disassembled.
FIG. 5B is a view diagram a state in which the hinge device according to various embodiments of the disclosure is assembled.
FIG. 5C is a perspective view of a portion of the hinge device corresponding to area 5c in FIG. 5B according to various embodiments of the disclosure.
FIG. 5D is a perspective view of hinge cams according to various embodiments of the disclosure.
FIG. 5E is a partial cross-sectional view illustrating a state in which the hinge cams according to various embodiments of the disclosure are facing each other.
FIG. 6 is a view illustrating the configuration of a portion of a hinge device including a shielding member according to various embodiments of the disclosure.
FIG. 7 is a view illustrating the configuration of a hinge device according to various embodiments of the disclosure.
FIG. 8A is an exploded perspective view illustrating a state in which a pair of springs are applied between hinge cams according to various embodiments of the disclosure.
FIG. 8B is a view illustrating the configuration of the hinge device to which the pair of springs illustrated in FIG. 8A are applied, according to various embodiments of the disclosure.
FIG. 9 is a view illustrating the arrangement structures of magnets according to various embodiments of the disclosure.
FIG. 10 is an exploded perspective view of a hinge device in which a pair of springs are applied according to various embodiments of the disclosure.
FIG. 11A is a view illustrating the configuration of the hinge device to which the pair of springs illustrated in FIG. 10 are applied, according to various embodiments of the disclosure.
FIG. 11B is a partial cross-sectional view of the electronic device according to various embodiments of the disclosure taken along line 11b-11b in FIG. 11A.
FIGS. 12A and 12B are perspective views of a hinge device with a detent structure according to various embodiments of the disclosure.

### [Mode for the Invention]

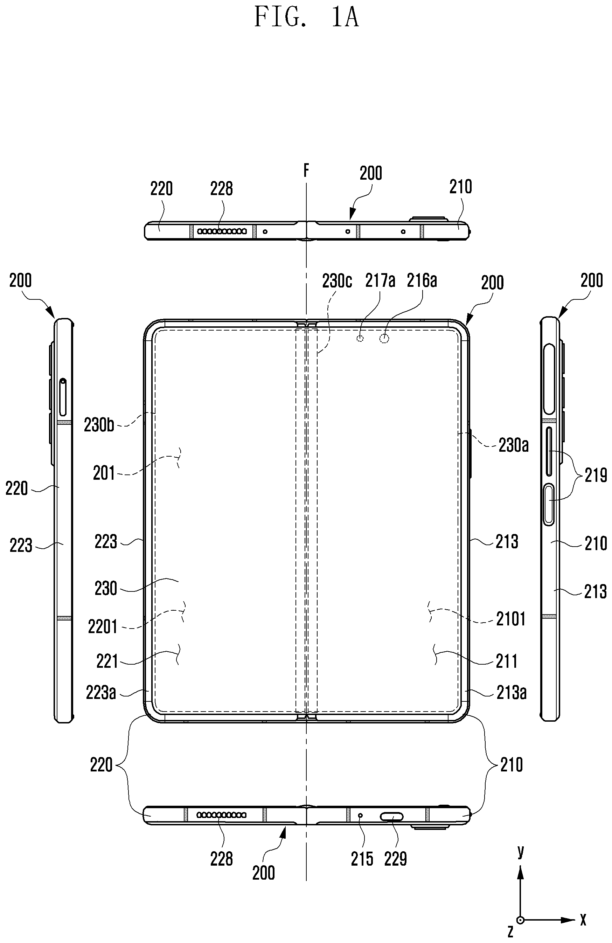

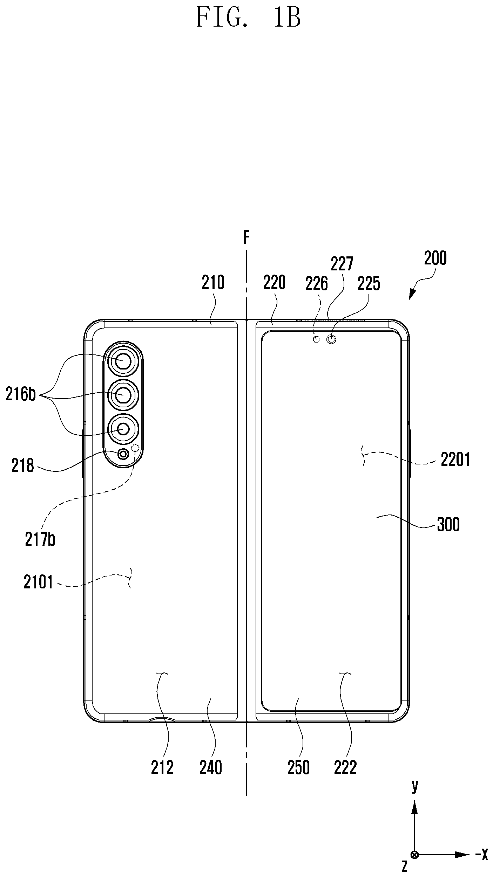

FIGS. 1A and 1B are diagrams illustrating a front view and a rear view, respectively, of an unfolded state of an electronic device according to various embodiments.

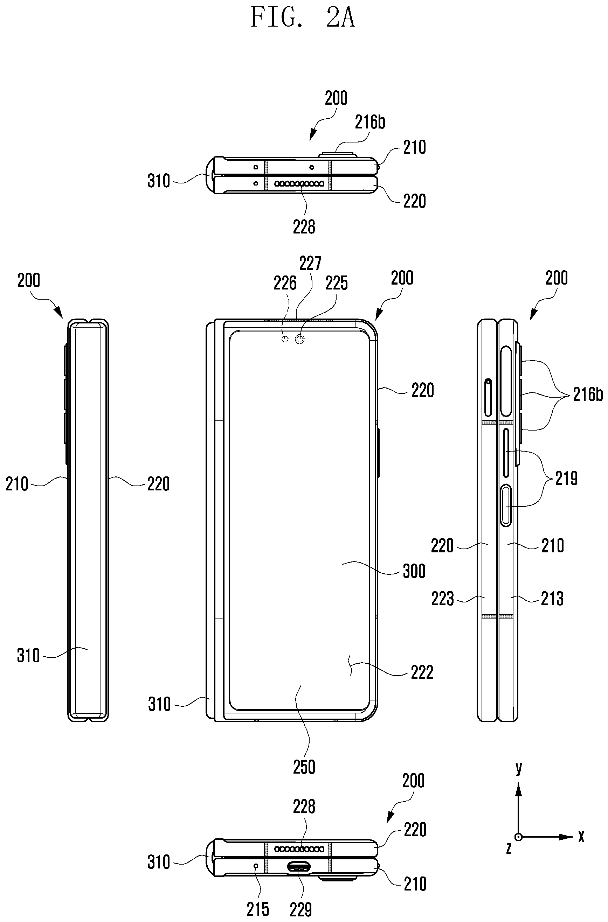

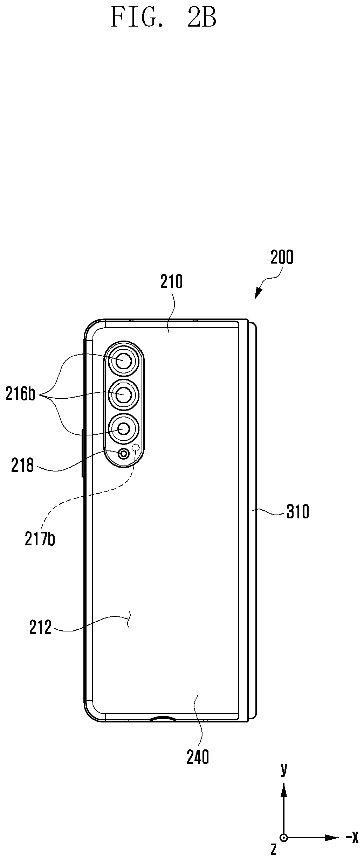

FIGS. 2A and 2B are diagrams illustrating a front view and a rear view, respectively, of a folded state of an electronic device according to various embodiments.

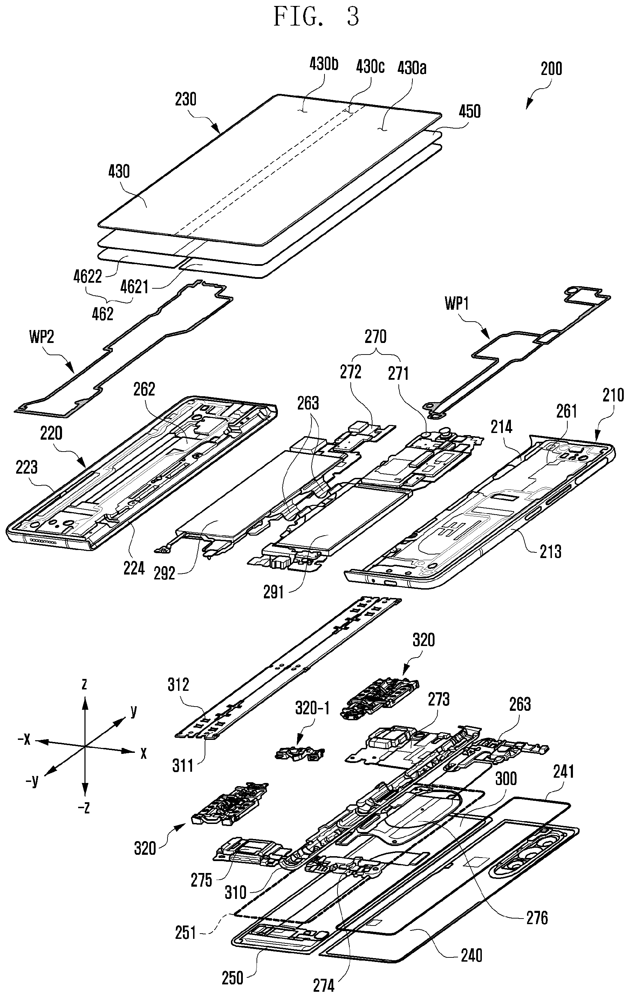

Referring to FIGS. 1A, 1B, 2A and 2B (which may be referred to as FIGS. 1A to 2B), an electronic device 200 may include a pair of housings 210 and 220 (e.g., a foldable housing structure) rotatably coupled to each other with reference to folding axis A through a hinge device (e.g., a hinge device 320 of FIG. 3) (e.g., a hinge module) so as to be folded with respect to each other, a first display 230 (e.g., a flexible display, a foldable display, or a main display) disposed through the pair of housings 210 and 220, and/or a second display 300 (e.g., a sub display) disposed through the second housing 220. According to an embodiment, at least a part of the hinge device (e.g., the hinge device 320 of FIG. 3) may be disposed so as not to be seen from the outside through the first housing 210 and the second housing 220, and may be disposed so as not to be seen from the outside through the hinge housing 310 covering a foldable portion. According to an embodiment, the hinge device 320 may include a hinge module including a gear assembly including multiple gears and multiple hinge cams which are coupled to hinge shafts rotating through the gear assembly and perform a cam interlocking operation, and hinge plates for connecting the hinge model to the first housing 210 and the second housing 220. In the disclosure, a surface in which the first display 230 is disposed may be defined as a front surface of the electronic device 200, and a surface opposite to the front surface may be defined as a rear surface of the electronic device 200. In addition, a surface surrounding a space between the front surface and the rear surface may be defined as a side surface of the electronic device 200.

According to various embodiments, the pair of housings 210 and 220 may include a first housing 210 and a second housing 220 foldably arranged with respect to each other through the hinge device (e.g., the hinge device 320 of FIG. 3). According to an embodiment, the shape and the coupling of the pair of housings 210 and 220 are not limited to those illustrated in FIGS. 1A to 2B, and the pair of housings 210 and 220 may be implemented by a combination and/or coupling of other shapes or components. According to an embodiment, the first housing 210 and the second housing 220 may be arranged on opposite sides with reference to the folding axis A, and may have shapes that are entirely symmetric to each other with respect to the folding axis A. According to an embodiment, the first housing 210 and the second housing 220 may be asymmetrically folded with reference to the folding axis A. According to an embodiment, the angle or the distance between the first housing 210 and the second housing 220 may vary depending on whether the electronic device 200 is in an unfolded state, a folded state, or an intermediate state.

According to various embodiments, the first housing 210 may include, in the unfolded state of the electronic device 200, a first surface 211 connected to the hinge device (e.g., the hinge device 320 of FIG. 3) and disposed to be oriented to the front surface of the electronic device 200, a second surface 212 oriented in a direction opposite to the first surface 211, and/or a first side member 213 surrounding at least a part of a first space between the first surface 211 and the second surface 212. According to an embodiment, the second housing 220 may include, in the unfolded state of the electronic device 200, a third surface 221 connected to the hinge device (e.g., the hinge device 320 of FIG. 3) and disposed to be oriented to the front surface of the electronic device 200, a fourth surface 222 oriented in a direction opposite to the third surface 221, and/or a second side member 223 surrounding at least a part of a second space between the third surface 221 and the fourth surface 222. According to an embodiment, the first surface 211 and the third surface 221 may be oriented in substantially the same direction in the unfolded state, and the first surface 211 and the third surface 221 may at least partially face each other in the folded state. According to an embodiment, the electronic device 200 may include a recess 201 formed to receive the first display 230 through structural coupling of the first housing 210 and the second housing 220. According to an embodiment, the recess 201 may have substantially the same shape as the first display 230. According to an embodiment, the first housing 210 may include a first protection frame 213a (e.g., a first decoration member) which is, when seen from above the first display 230, coupled to the first side member 213, disposed to overlap with an edge of the first display 230, so as to cover the edge of the first display 230 to allow the same not to be seen from the outside. According to an embodiment, the first protection frame 213a may be integrally formed with the first side member 213. According to an embodiment, the second housing 220 may include a second protection frame 223a (e.g., a second decoration member) which is, when seen from above the first display 230, coupled to the second side member 223, disposed to overlap with an edge of the first display 230, so as to cover the edge of the first display 230 to allow the same not to be seen from the outside. According to an embodiment, the second protection frame 223a may be integrally formed with the first side member 223. In an embodiment, the first protection frame 213a and the second protection frame 223a may be omitted.

According to various embodiments, the hinge housing 310 (e.g., a hinge cover) may be disposed between the first housing 210 and the second housing 220, and may be disposed to cover a part (e.g., at least one hinge module) of the hinge device (e.g., the hinge device 320 of FIG. 3) disposed on the hinge housing 310. According to an embodiment, the hinge housing 310 may be hidden or exposed from or to the outside by a part of the first housing 210 and the second housing 220 according to the unfolded state, the folded state, or the intermediate state of the electronic device 200. For example, when the electronic device 200 is in the unfolded state, at least a part of the hinge housing 310 may be covered by the first housing 210 and the second housing 220 and not be substantially exposed. According to an embodiment, when the electronic device 200 is in the folded state, at least a part of the hinge housing 310 may be exposed to the outside between the first housing 210 and the second housing 220. According to an embodiment, in the intermediate state in which the first housing 210 and the second housing 220 are folded with each other by a predetermined angle (folded with a certain angle), the hinge housing 310 may be at least partially exposed to the outside of the electronic device 200 between the first housing 210 and the second housing 220. For example, an area in which the hinge housing 310 is exposed to the outside, may be smaller than that in a case in which the electronic device 200 is completely folded. According to an embodiment, the hinge housing 310 may include a curved surface.

According to various embodiments, when the electronic device 200 is in the unfolded state (e.g., the states shown in FIGS. 1A and 1B), the first housing 210 and the second housing 220 may meet at an about 180-degree angle, and a first area 230a, a second area 230b, and a folding area 230c of the first display 230 may form the same plane and arranged to be oriented in substantially the same direction (e.g., a z-axis direction). In an embodiment, when the electronic device 200 is in the unfolded state, the first housing 210 may rotate by an about 360-degree angle with respect to the second housing 220, and may be outwardly folded (an out-folding scheme) so that the second surface 212 and the fourth surface 222 face each other.

According to various embodiments, when the electronic device 200 is in the folded state (e.g., the states shown in FIGS. 2A and 2B), the first surface 211 of the first housing 210 and the third surface 221 of the second housing 220 may be arranged to face each other. In this case, the first area 230a and the second area 230b of the first display 230 may form a narrow angle (e.g., a range between 0 degrees to about 10 degrees) through the folding area 230c, and may be arranged to face each other. According to an embodiment, at least a part of the folding area 230c may be deformed into a curved shape having a predetermined curvature. According to an embodiment, when the electronic device 200 is in the intermediate state, the first housing 210 and the second housing 220 may be arranged at a predetermined angle (a certain angle). In this case, the first area 230a and the second area 230b of the first display 230 may form an angle that is greater than that in the folded state and smaller than that in the unfolded state, and the curvature of the folding area 230c may be lower than that in the folded state, and may be higher than that in the unfolded state. In an embodiment, the first housing 210 and the second housing 220 may form an angle which allows stopping at a designated folding angle between the folded state and the unfolded state (a free stop function), through the hinge device (e.g., the hinge device 320 of FIG. 3). In an embodiment, the first housing 210 and the second housing 220 may continuously operate while being pressed in an unfolding direction or a folding direction with reference to a designated inflection angle, through the hinge device (e.g., the hinge device 320 of FIG. 3).

According to various embodiments, the electronic device 200 may include at least one of at least one display 230 and 300 disposed on the first housing 210 and/or the second housing 220, an input device 215, sound output devices 227 and 228, sensor modules 217a, 217b, and 226, camera modules 216a, 216b, and 225, a key input device 219, an indicator (not shown), or a connector port 229. In an embodiment, the electronic device 200 may omit at least one of the elements, or may additionally include at least one another element.

According to various embodiments, the at least one display 230 and 300 may include a first display 230 (e.g., a flexible display) disposed to be supported by the third surface 221 of the second housing 220 from the first surface 211 of the first housing 210 through the hinge device (e.g., the hinge device 320 of FIG. 3), and a second display 300 disposed to be at least partially seen from the outside through the fourth surface 222 in a space in the second housing 220. In an embodiment, the second display 300 may be disposed to be seen from the outside through the second surface 212 in a space in the first housing 210. According to an embodiment, the first display 230 may be mainly used in the unfolded state of the electronic device 200, and the second display 300 may be mainly used in the folded state of the electronic device 200. According to an embodiment, the electronic device 200 may control, in the intermediate state, the first display 230 and/or the second display 300 to be used, based on a folding angle between the first housing 210 and the second housing 220.

According to various embodiments, the first display 230 may be disposed in a receiving space formed by the pair of housings 210 and 220. For example, the first display 200 may be disposed in a recess 201 formed by the pair of housings 210 and 220, and may be disposed to occupy substantially the most of the front surface of the electronic device 200in the unfolded state. According to an embodiment, the first display 230 may include a flexible display having at least one area which can be deformed into a plane or a curved surface. According to an embodiment, the first display 230 may include the first area 230a facing the first housing 210 and the second area 230b facing the second housing 220. According to an embodiment, the first display 230 may include the folding area 230c including a part of the first area 230a and a part of the second area 230b with respect to the folding axis A. According to an embodiment, at least a part of the folding area 230c may include an area corresponding to the hinge device (e.g., the hinge device 320 of FIG. 3). According to an embodiment, a division of an area of the first display 230 merely corresponds to an example physical division by the pair of housings 210 and 220 and the hinge device (e.g., the hinge device 320 of FIG. 3), and the first display 230 may be substantially displayed as one seamless full screen through the pair of the housings 210 and 220 and the hinge device (e.g., the hinge device 320 of FIG. 3). According to an embodiment, the first area 230a and the second area 230b may have shapes that are entirely symmetric or partially asymmetric to each other with respect to the folding area 230c.

According to various embodiments, the electronic device 200 may include a first rear cover 240 disposed on the second surface 212 of the first housing 210 and a second rear cover 250 disposed on the fourth surface 222 of the second housing 220. In an embodiment, at least a part of the first rear cover 240 may be integrally formed with the first side member 213. In an embodiment, at least a part of the second rear cover 250 may be integrally formed with the second side member 223. According to an embodiment, at least one of the first rear cover 240 and the second rear cover 250 may be substantially formed of a transparent plate (e.g., a polymer plate or glass plate including various coding layers) or an opaque plate. According to an embodiment, the first rear cover 240 may be formed of, for example, an opaque plate such as coded or colored glass, ceramic, polymer, metal (e.g., aluminum, stainless steel (STS), or magnesium), or a combination of at least two of the materials above. According to an embodiment, the second rear cover 250 may be substantially formed of, for example, a transparent plate such as glass or polymer. Accordingly, the second display 300 may be disposed to be seen from the outside through the second rear cover 250 in a space in the second housing 220.

According to various embodiments, the input device 215 may include a microphone. In an embodiment, the input device 215 may include multiple microphones arranged to detect the direction of sound. According to an embodiment, the sound output devices 227 and 228 may include speakers. According to an embodiment, the sound output devices 227 and 228 may include a call receiver 227 disposed through the fourth surface 222 of the second housing 220 and an external speaker 228 disposed through at least a part of the second side member 223 of the second housing 220. In an embodiment, the input device 215, the sound output devices 227 and 228, and the connector 229 may be disposed in spaces of the first housing 210 and/or the second housing 220, and may be exposed to an external environment through at least one hole formed through the first housing 210 and/or the second housing 220. In an embodiment, holes formed through the first housing 210 and/or the second housing 220 may be commonly used for the input device 215 and the sound output devices 227 and 228. In an embodiment, the sound output devices 227 and 228 may include a speaker (e.g., a piezo speaker) operating without including a hole formed through the first housing 210 and/or the second housing 220.

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the electronic device 200 may include a flash 218 disposed around the second camera module 216b. According to an embodiment, the flash 218 may include, for example, a light-emitting diode or a xenon lamp. According to an embodiment, the camera modules 216a, 216b, and 225 may include one or multiple lenses, an image sensor, and/or an image signal processor. In an embodiment, at least one of the camera modules 216a, 216b, and 225 may include two or more lenses (e.g., wide-angle and telephoto lenses) and image sensors, and may be arranged together on one surface of the first housing 210 and/or the second housing 220.

According to various embodiments, the sensor modules 217a, 217b, and 226 may generate a data value or an electrical signal corresponding to an internal operational state or an external environmental state of the electronic device 200.According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In an embodiment, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., a time of flight (TOF) sensor or a light detection and ranging (LiDAR)).

According to various embodiments, the electronic device 200 may further include an unillustrated sensor module, for example, at least one of an atmospheric sensor, a magnetic sensor, a biometric sensor, a temperature sensor, a humidity sensor, or a fingerprint recognition sensor. In an embodiment, the fingerprint recognition sensor may be disposed through at least one of the first side member 213 of the first housing 210 and/or the second side member 223 of the second housing 220.

According to various embodiments, the key input device 219 may be disposed to be exposed to the outside through the first side member 213 of the first housing 210. In an embodiment, the key input device 219 may be disposed to be exposed to the outside through the second side member 223 of the second housing 220. In an embodiment, the electronic device 200 may not include some or all of the key input device 219, and the unincluded key input device 219 may be implemented in another shape such as a soft key on the least one display 230 and 300. In an embodiment, the key input device 219 may be implemented using a pressure sensor included in the at least one display 230 and 300.

According to various embodiments, the connector port 229 may include a connector (e.g., a USB connector or an IF module (an interface connector port module)) for transmitting or receiving data and/or power to and/or from an external electronic device. In an embodiment, the connector port 229 may perform a function of transmitting or receiving an audio signal to or from the external electronic device together, or may further include a separate connector port (e.g., an ear jack hole) for performing a function of transmitting or receiving an audio signal to or from the external electronic device.

According to various embodiments, at least one camera modules 216a and 225 of the camera modules 216a, 216b, and 225, at least one sensor module 217a and 226 of the sensor modules 217a, 217b, and 226, and/or an indicator may be arranged to be exposed through the at least one display 230 and 300. For example, the at least one camera modules 216a and 225, the at least one sensor module 217a and 226, and/or the indicator may be arranged under an activated area (a display area) of the at least one display 230 and 300 in a space in the at least one housing 210 and 220, and may be arranged to come into contact with an external environment through a transparent area or an opening that is perforated to a cover member (e.g., a window layer (not shown) of the first display 230 and/or the second rear cover 250). According to an embodiment, an area in which the at least one display 230 and 300 and the at least one camera module 216a and 225 face each other may be formed as a transmission area having a predetermined transmission ratio, as a part of an area in which a content is displayed. According to an embodiment, the transmission area may be formed to have a transmission ratio in the range of about 5% to about 20%. The transmission area may include an area overlapping with an effective area (e.g., an angle of view area) of the at least one camera module 216a and 225, wherein an image is formed on the image sensor in the effective area, and light for generating an image passes through the effective area. For example, the transmission area of the display 230 and 300 may include an area in which the density of a pixel is lower than that in a surrounding area. For example, the transmission area may be replaced with an opening. For example, the at least one camera module 216a and 225 may include an under-display camera (UDC) or an under-panel camera (UPC). In an embodiment, some camera modules or sensor modules 271a and 226 may be arranged to perform functions thereof without being visually exposed through the display. For example, an area facing the sensor module 217a and 226 and/or the camera module 216a and 225 arranged under the display 230 and 300 (e.g., a display panel) corresponds to an under-display camera (UDC) structure, and a perforated opening is not necessarily required.

FIG. 3 is an exploded perspective view of an electronic device according to various embodiments.

With reference to FIG. 3, an electronic device 200 may include a first display 230 (e.g., a flexible display), a second display 300, at least one hinge device 400 and 400-1, a pair of support members 261 and 262, at least one board 270 (e.g., printed circuit board (PCB)), a first housing 210, a second housing 220, a first rear cover 240, and/or a second rear cover 250.

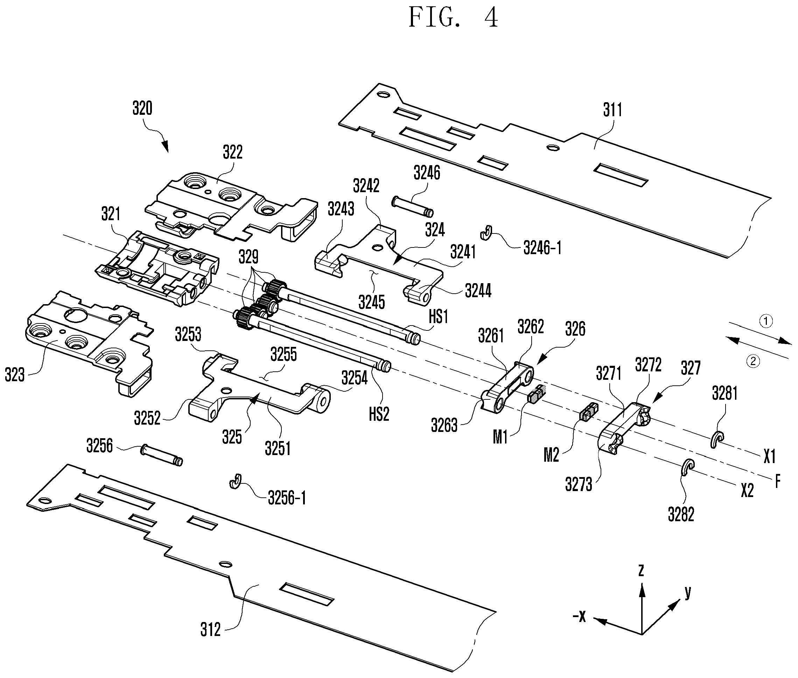

According to various embodiments, the first display 230 may include a display panel 430 (e.g., a flexible display panel), and a support plate 450 disposed under the display panel 430. In an embodiment, the first display 230 may include a reinforcement plate 462 disposed under the support plate 450. In a certain embodiment, the reinforcement plate 462 may be omitted. In an embodiment, the display panel 430 may include a first panel area 430a corresponding to a first area (e.g., the first area 230a of FIG. 1A) of the first display 230, a second panel area 430b extending from the first panel area 430a, and corresponding to a second area (e.g., the second area 230b of FIG. 1A) of the first display 230, and a third panel area 430c connecting the first panel area 430a and the second panel area 430b, and corresponding to a folding area (e.g., the folding area 230c of FIG. 1A) of the first display 230. In an embodiment, the support plate 450 may be disposed between the display panel 430 and a pair of support members 261 and 262, and may be formed to have a material and a shape for providing a flat type support structure for the first panel area 430a and the second panel area 430b and a bendable structure to help flexibility of the third panel area 430c. In an embodiment, the support plate 450 may be formed of a conductive material (e.g., metal) or a non-conductive material (e.g., polymer or fiber reinforced plastics (FRP). In an embodiment, the reinforcement plate 462 may include a first reinforcement plate 4621 disposed to correspond to at least a part of the first panel area 430a and the third panel area 430c and a second reinforcement plate 4622 disposed to correspond to at least a part of the second panel area 430b and the third panel area 430c between the support plate 450 and a pair of support members 261 and 262. In an embodiment, since the reinforcement plate 462 is formed of a metal material (e.g., SUS), it may help a ground connection structure and stiffness reinforcement for the first display 230. In a certain embodiment, the electronic device 200 may include a digitizer (e.g., the digitizer 461 of FIG. 4) which is disposed under the support plate 450, which is replaced by the reinforcement plate 462, or which is added between the support plate 450 and the reinforcement plate 462.

According to various embodiments, the second display 300 may be disposed in a space between the second housing 220 and the second rear cover 250. In an embodiment, the second display 300 may be disposed to be able to be viewed from an outside through substantially the whole area of the second rear cover 250 in the space between the second housing 220 and the second rear cover 250.

According to various embodiments, at least a part of the first support member 261 may be combined with the second support member 262 in a foldable manner through at least one hinge device 400 and 400-1. In an embodiment, the electronic device 200 may include at least one wiring member 263 (e.g., flexible printed circuit board (FPCB)) disposed from at least a part of the first support member 261 to a part of the second support member 262 across the at least one hinge device 400 and 400-1. In an embodiment, the first support member 261 may be disposed to extend from the first lateral member 213 or to be structurally combined with the first lateral member 213. In an embodiment, the electronic device 200 may include a first space (e.g., first space 2101 of FIG. 1A) provided through the first support member 261 and the first rear cover 240. In an embodiment, the first housing 210 (e.g., first housing structure) may be provided through a combination of the first lateral member 213, the first support member 261, and the first rear cover 240. In an embodiment, the second support member 262 may be disposed to extend from the second lateral member 223 or to be structurally combined with the second lateral member 223. In an embodiment, the electronic device 200 may include a second space (e.g., second space 2201 of FIG. 1A) provided through the second support member 262 and the second rear cover 250. In an embodiment, the second housing 220 (e.g., second housing structure) may be formed through a combination of the second lateral member 223, the second support member 262, and the second rear cover 250. In an embodiment, at least parts of the at least one wiring member 263 and/or the at least one hinge device 400 and 400-1 may be disposed to be supported through the at least one of the pair of support members 261 and 262. In an embodiment, the at least one wiring member 263 may be disposed to extend from the first support member 261 to the second support member 262 across the folding axis F. In an embodiment, the at least one wiring member 263 may be disposed to have a length in a direction (e.g., x-axis direction) substantially vertical to the folding axis (e.g., y axis or folding axis F of FIG. 1A).

According to various embodiments, at least one substrate 270 may include a first substrate 271 disposed in the first space 2101 and a second substrate 272 disposed in the second space 2201. In an embodiment, the first board 271 and the second substrate 272 may include a plurality of electronic components disposed to implement various functions of the electronic device 200. In an embodiment, the first substrate 271 and the second substrate 272 may be electrically connected through the at least one wiring member 263.

According to various embodiments, the electronic device 200 may include at least one battery 291 and 292. In an embodiment, the at least one battery 291 and 292 may include the first battery 291 disposed in the first space 2101 of the first housing 210 and electrically connected to the first substrate 271, and the second battery 292 disposed in the second space 2201 of the second housing 220 and electrically connected to the second substrate 272. In an embodiment, the first support member 261 and the second support member 262 may further include at least one swelling hole for the first battery 291 and the second battery 292.

According to various embodiments, the first housing 210 may include a first rotation support surface 214, and the second housing 220 may include a second rotation support surface 224 corresponding to the first rotation support surface 214. In an embodiment, the first rotation support surface 214 and the second rotation support surface 224 may include a curved surface corresponding (naturally connected) to a curved outer surface of a hinge housing 310. In an embodiment, the first rotation support surface 214 and the second rotation support surface 224 hide the hinge housing 310 in case the electronic device 200 is in an unfolding state, and thus the hinge housing 310 may not be exposed to the rear surface of the electronic device, or only a part thereof may be exposed. **In** an embodiment, in case the electronic device 200 is in a folding state, the first rotation support surface 214 and the second rotation support surface 224 may be rotated along the curved outer surface of the hinge housing 310 to expose at least a part of the hinge housing 310 to the rear surface of the electronic device 200.

According to various embodiments, the electronic device 200 may include at least one antenna 276 disposed in the first space 2201. In an embodiment, the at least one antenna 276 may be disposed on the first battery 291 and the first rear cover 240 in the first space 2201. In an embodiment, the at least one antenna 276 may include, for example, a near field communication (NFC) antenna, a wireless charging antenna, and/or a magnetic secure transmission (MST) antenna. In an embodiment, the at least one antenna 276, for example, may perform short range communication with an external device, or may wirelessly transmit and receive a power required for charging. In a certain embodiment, an antenna structure may be formed by at least a part of the first lateral member 213 or the second lateral member 223 and/or parts of the first support member 261 and the second support member 262 or a combination thereof.

According to various embodiments, the electronic device 200 may further include at least one electronic component assembly 274 and 275 and/or additional support members 263 and 273 disposed in the first space (e.g., first space 2101 of FIG. 1A) and/or the second space (e.g., second space 2201 of FIG. 1A). For example, the at least one electronic component assembly may include an interface connector port assembly 274 or a speaker assembly 275.

According to various embodiments, the electronic device 200 may include a first waterproof member WP1 disposed between the first reinforcement plate 4621 and the first support member 261 and a second waterproof member WP2 disposed between the second reinforcement plate 4622 and the second support member 262. In an embodiment, the first waterproof member WP1 may provide at least one first waterproof space between the first reinforcement plate 4621 and the first support member 261. In an embodiment, the at least one first waterproof space may accommodate an area corresponding to at least one electronic component (e.g., camera module or sensor module) disposed to be supported by the first support member 261. In an embodiment, the second waterproof member WP2 may provide a second waterproof space between the second reinforcement plate 4622 and the second support member 262. In an embodiment, the second waterproof space may accommodate at least a part of a bending part that is folded over the rear surface of the first display 230.

According to various embodiments, the electronic device 200 may include a waterproof tape 241 disposed between the first rear cover 240 and the first housing 210. In an embodiment, the electronic device 200 may include a bonding member 251 disposed between the second rear cover 250 and the second housing 220. In a certain embodiment, the bonding member 251 may also be disposed between the second display 300 and the second housing 220. In a certain embodiment, the waterproof tape 241 may be replaced by the bonding member 251, and the bonding member 251 may be replaced by the waterproof tape 241.

According to various embodiments, the at least one hinge device 320 may include a pair of hinge devices 320 disposed at opposite ends thereof in a direction parallel to the folding axis F. In some embodiments, three or more hinge devices 320 may be arranged at a predetermined interval along the folding axis F, or one hinge device 320 may be arranged along the folding axis F1. In an embodiment, the electronic device 200 may include a connection module 320-1 disposed between the hinge devices 320. In an embodiment, the connection module 320-1 may be disposed through a combination of one or more gears and/or a combination of one or more links. In some embodiments, the connection module 400-2 may be replaced with the hinge devices 320. In an embodiment, the electronic device 200 may include a first hinge plate 311 and a second hinge plate 312 connected via the at least one hinge device 320. In an embodiment, in the unfolded state, the first hinge plate 311 may form **the same** plane as the first housing 210, and, in the unfolded state, the second hinge plate 312 may form the same plane as the second housing 220.

According to exemplary embodiments of the disclosure, in the hinge device 320, as means for biasing the hinge cams (e.g., the hinge cams 326 and 327 in FIG. 4) in opposite directions, coil springs may be excluded, and may be replaced with magnets (e.g., magnets M1 and M2 in FIG. 4) arranged with identical polarities facing each other. Through the arrangement structure of the magnets M1 and M2 replacing the coil springs, the hinge device 320 may be reduced in size, contributing to the slimming of the electronic device 200.

FIG. 4 is an exploded perspective view of a hinge device according to various embodiments of the disclosure.

The hinge device illustrated in FIG. 4 may be at least partially similar to the hinge device 320 illustrated in FIG. 3 or may further include other embodiments of the hinge device.

Referring to FIG. 4, the electronic device (e.g., electronic device 200 in FIG. 3) may include a first housing (e.g., the first housing 210 in FIG. 3), a second housing (e.g., the second housing 220 in FIG. 3), and a hinge device 320 that foldably connects the first housing 210 and the second housing 220. In an embodiment, the hinge device 320 may be fixed in an accommodation portion (e.g., the accommodation portion 3101 in FIG. 3) of the hinge housing (e.g., the hinge housing 310 in FIG. 3) and may be arranged to at least partially connect the first housing 210 and the second housing 220.

According to various embodiments, the hinge device 320 may include a rotator bracket 321 fixed to a hinge housing (e.g., the hinge housing 310 in FIG. 3), a first rotator 322 fixed to one side of the rotator bracket 321 to be rotatable around the folding axis F, a second rotator 323 fixed to the other side of the rotator bracket 321 to be rotatable around the folding axis F, a first arm 324 coupled to the first rotator 322 and arranged to be rotatable about a first rotation axis X1 via a first shaft HS1 arranged parallel to the folding axis F on one side of the folding axis F, a second arm 325 coupled to the second rotator 323 and arranged to be rotatable about a second rotation axis X2 via a second shaft HS2 arranged parallel to the folding axis F on the other side of the folding axis F, a pair of hinge cams 326 and 327 arranged in such a way that the first shaft HS1 and the second shaft HS2 pass through the hinge cams, and magnets M1 and M2 arranged in such a way that the first shaft HS1 and the second shaft HS2 pass through the magnets and disposed between the pair of hinge cams 326 and 327 to bias the hinge cams 326 and 327 against each other in opposite directions (e.g., direction ① or direction ②). In an embodiment, the first rotator 322 may be connected to a first hinge plate 311 coupled to the first housing (e.g., the first housing 210 in FIG. 1A). In an embodiment, the second rotator 323 may be connected to a second hinge plate 312 coupled to the second housing (e.g., the second housing 220 in FIG. 1A). In an embodiment, the hinge device 320 may include E-rings 3281 and 3282 (or O-rings) fixed to the ends of the first and second shafts HS1 and HS2 to prevent one side of the first arm 324 and the first and second hinge cams 326 and 327, through which the first shaft HS1 passes, and the other side of the second arm 325 and the first and second hinge cams 326 and 327, through which the second shaft HS2 passes, from being detached outward during operation.

According to various embodiments, the hinge device 320 may include gear assemblies 329, each of which includes multiple gears (e.g., spur gears) arranged, at one ends of the first shaft HS1 and the second shaft HS2, respectively. In an embodiment, the first arm 324 and the second arm 325 may be arranged to rotate with the same rotational amount relative to the folding axis F through the gear assemblies 329, respectively. For example, the first shaft HS1 and the second shaft HS2 may be arranged to rotate together when the first rotator 322 and the second rotator 323, which rotate about the folding axis in the rotator bracket are linked (pivotally connected) to the first rotator 322 and the second rotator 323, respectively, and the first arm 324 and the second arm 325 rotate about the first rotation axis X1 and the second rotation axis X2, respectively.

According to various embodiments, the first arm 324 may include a first body 3241, a first rotator coupling portion 3242 extending from one end of the first body 3241 and coupled to the first rotator 322, a first cam structure 3243 extending from the other end of the first body 3241, and a second cam structure 3244 extending from the other end of the first body 3241 to have a first cam accommodation space 3245 along with the first cam structure 3243. In an embodiment, the first rotator coupling portion 3242 may be rotatably coupled to the first rotator 322 through a coupling pin 3246 and an E-ring 3246-1. In an embodiment, the first cam structure 3243 and the second cam structure 3244 may be coupled to rotate together with the first shaft HS1 in such a way that the first shaft HS1 passes through the first and second cam structures.

According to various embodiments, the second arm 325 may include a second body 3251, a second rotator coupling portion 3252 extending from one end of the second body 3251 and coupled to the second rotator 323, a third cam structure 3253 extending from the other end of the second body 3251, and a fourth cam structure 3254 extending from the other end of the second body 3251 to have a second cam accommodation space 3255 along with the third cam structure 3253. In an embodiment, the second rotator coupling portion 3252 may be rotatably coupled to the second rotator 323 through a coupling pin 3256 and an E-ring 3256-1. In an embodiment, the third cam structure 3253 and the fourth cam structure 3254 may be coupled to rotate together with the second shaft HS2 in such a way that the second shaft HS2 passes through the third and fourth cam structures. In an embodiment, the second arm 325 may have a shape symmetrically identical to that of the first arm 324.

According to various embodiments, the pair of hinge cams 326 and 327 may be commonly accommodated in the first cam accommodation space 3245 and the second cam accommodation space 3255. In an embodiment, the first hinge cam 326 may include a first cam body 3261, a fifth cam structure 3262 extending from the first cam body 3261 and disposed in the first cam accommodation space 3245, and a sixth cam structure 3263 extending from the first cam body 3261 and disposed in the second cam accommodation space **3255. In** an embodiment, the fifth cam structure 3262 may be coupled to the first shaft HS1 to be movable in a direction parallel to the folding axis F in such a way that the first shaft HS1 passes through the fifth cam structure. In an embodiment, the sixth cam structure 3263 may be coupled to the second shaft HS2 to be movable in a direction parallel to the folding axis F in such a way that the second shaft HS2 passes through the sixth cam structure.

According to various embodiments, the second hinge cam 327 may include a second cam body 3271, a seventh cam structure 3272 extending from the second cam body 3271 and disposed in the first cam accommodation space 3245, and an eighth cam structure 3273 extending from the second cam body 3271 and disposed in the second cam accommodation space 3255. In an embodiment, the seventh cam structure 3272 may be coupled to the first shaft HS1 to be movable in a direction parallel to the folding axis F in such a way that the first shaft HS1 passes through the seventh cam structure. In an embodiment, the eighth cam structure 3273 may be coupled to the second shaft HS2 to be movable in a direction parallel to the folding axis F in such a way that the second shaft HS2 passes through the eighth cam structure. In an embodiment, the first cam structure 3243 may be arranged to face the fifth cam structure 3262, the second cam structure 3244 may be arranged to face the seventh cam structure 3272, the third cam structure 3253 may be arranged to face the sixth cam structure 3263, and the fourth cam structure 3254 may be arranged to face the eighth cam structure 3273. In an embodiment, each pair of facing cam structures may include a curved portion and a cam groove and may be cam-coupled with each other. Through the coupling of these cam structures, the electronic device 200 may receive a predetermined torque during folding and unfolding operations (e.g., including a free-stop function) and, when operating beyond a predetermined angle (e.g., an inflection angle), may receive a rotational force to automatically rotate in the folding or unfolding direction.

According to various embodiments, the hinge device 320 may include a pair of magnets M1 and M2 arranged between the first hinge cam 326 and the second hinge cam 327 such that identical polarities face each other. In an embodiment, the pair of magnets M1 and M2 may include a first magnet M1 disposed on the first cam body 3261 of the first hinge cam 326 and a second magnet M2 disposed on the second cam body 3271 of the second hinge cam 327. In an embodiment, the first hinge cam 326 may be biased toward the first cam structure 3243 of the first arm 324 and the third cam structure 3253 of the second arm 325 (e.g., direction ②) by the repulsive force generated by the pair of magnets M1 and M2. In an embodiment, the second hinge cam 327 may be biased toward the second cam structure 3244 of the first arm 324 and the fourth cam structure 3254 of the second arm 325 (e.g., direction ① by the repulsive force generated by the pair of magnets M1 and M2. In one embodiment, the hinge device 320 may include E-rings (or O-rings) 3281 and 3282 coupled as fixing means at the ends of the hinge shafts HS1 and HS2. In an embodiment, the E-rings 3281 and 3282 may prevent components (e.g., the first and second arms 324 and 325 and the first and second **hinge cams** 326 and 327) through which the shafts HS1 and HS2 pass, respectively, from being detached outward.

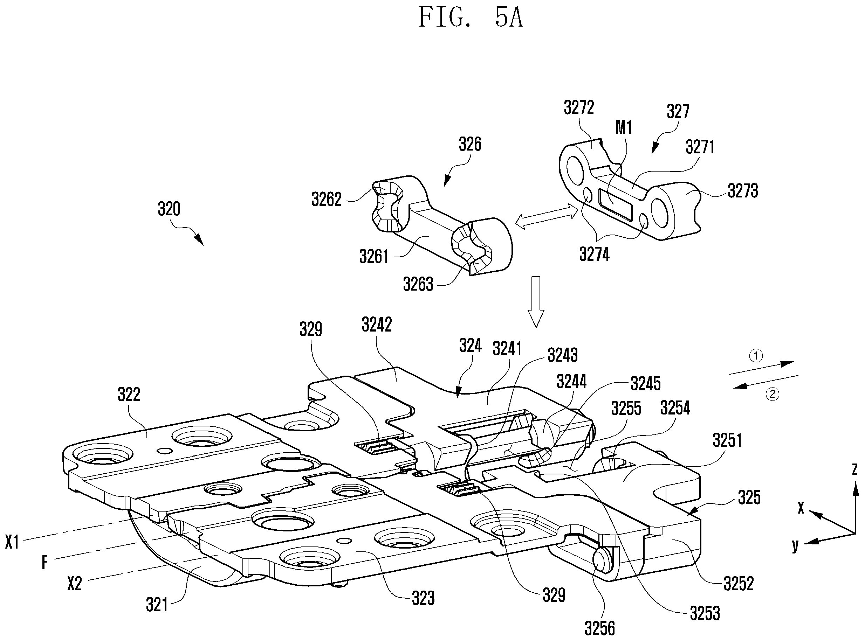

FIG. 5A is an exploded perspective view of a hinge device illustrating a state in which hinge cams and arms according to various embodiments of the disclosure are disassembled.

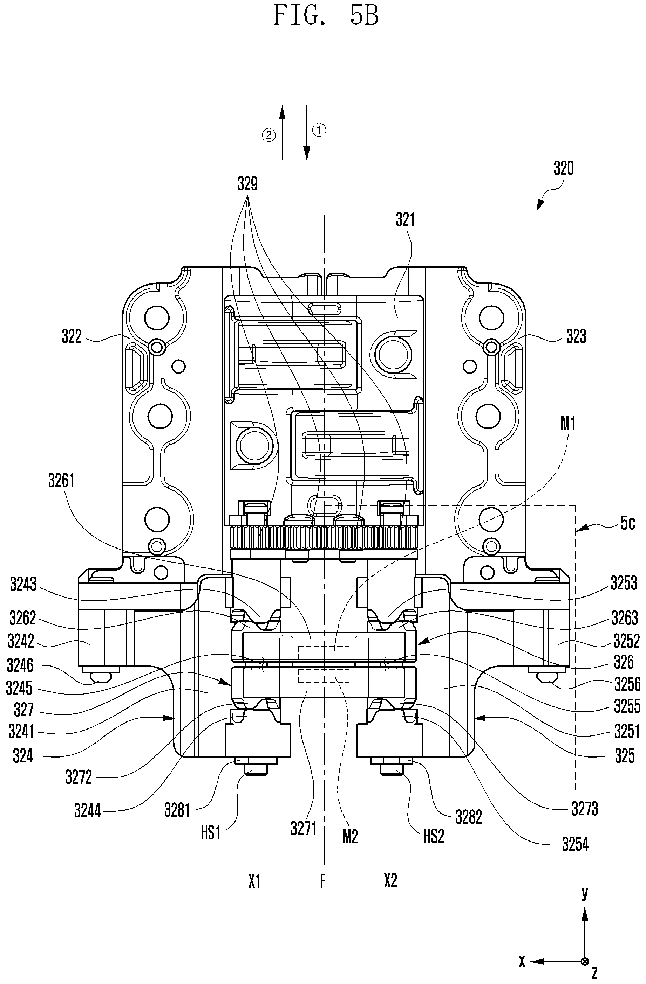

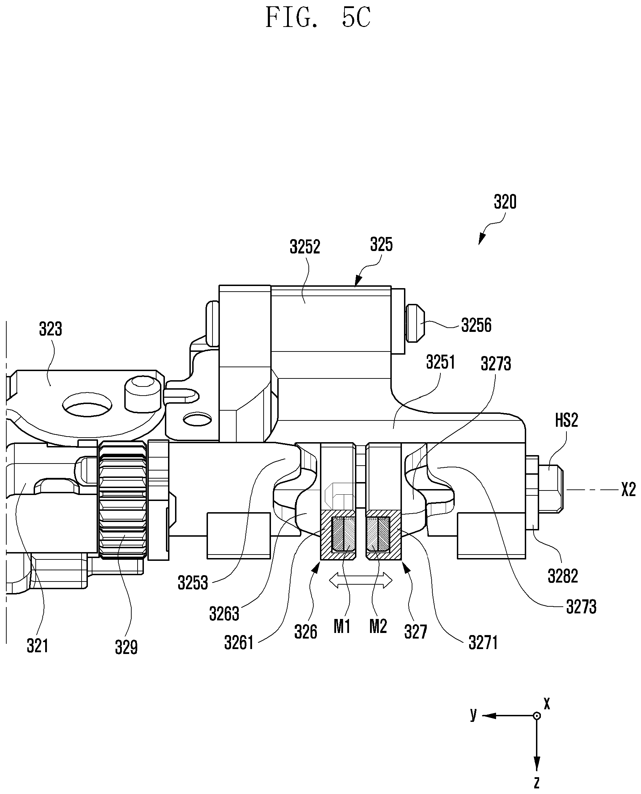

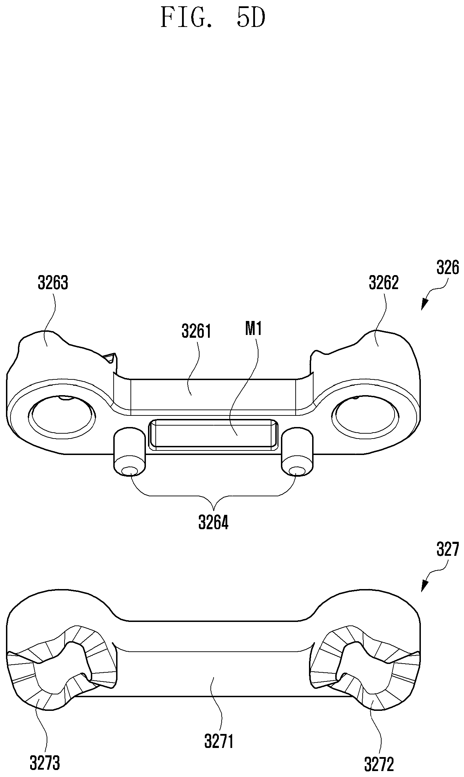

FIG. 5B is a view diagram a state in which the hinge device according to various embodiments of the disclosure is assembled. FIG. 5C is a perspective view of a portion of the hinge device corresponding to area 5c in FIG. 5D according to various embodiments of the disclosure.

In describing the hinge device 320 illustrated in FIGS. 5A to 5C, the same reference numerals are denoted for components identical to those of the hinge device 320 in FIG. 4, and detailed descriptions thereof may be omitted.

Referring to FIGS. 5A to 5C, the hinge device 320 may include a rotator bracket 321, a first rotator 322 fixed to one side of the rotator bracket 321 to be rotatable around the folding axis F, a second rotator 323 fixed to the other side of the rotator bracket 321 to be rotatable around the folding axis F, a first arm 324 coupled to the first rotator 322 and arranged to be rotatable about a first rotation axis X1 via a first shaft HS1 arranged parallel to the folding axis F on one side of the folding axis F, a second arm 325 coupled to the second rotator 323 and arranged to be rotatable about a second rotation axis X2 via a second shaft HS2 arranged parallel to the folding axis F on the other side of the folding axis F, a pair of hinge cams 326 and 327 arranged in such a way that the first shaft HS1 and the second shaft HS2 pass through the hinge cams, and magnets M1 and M2 arranged in such a way that the first shaft HS1 and the second shaft HS2 pass through the magnets and disposed between the pair of hinge cams 326 and 327 to bias the hinge cams 326 and 327 against each other in opposite directions (e.g., direction ① or direction ②).

According to various embodiments, the first magnet M1 may be fixed in a seated manner on the first cam body 3261 of the first hinge cam 326. In an embodiment, the second magnet M2 may be seated on the second cam body 3271 of the second hinge cam 327 and disposed at a position reacting to the magnetic force of the first magnet M1. In an embodiment, the first magnet M1 and the second magnet M2 may exert a repulsive force against each other. Through this, the first hinge cam 326 may be biased toward the first cam structure 3243 of the first arm 324 and the third cam structure 3253 of the second arm 325 (e.g., in direction ②) and the second hinge cam 327 may be biased toward the second cam structure 3244 of the first arm 324 and the fourth cam structure 3254 of the second arm 325 (e.g., in direction ①).

According to various embodiments, when the first housing (e.g., the first housing 210 in FIG. 1A) and the second housing (e.g., the second housing 220 in FIG. 1A) rotate, the first and second rotators 322 and 323 may rotate together about the folding axis F within the rotator bracket 321. In an embodiment, when the first and second rotators 322 and 323 rotate, the first and second arms 324 and 325 pivotally coupled thereto, as well as the first and second shafts HS1 and HS2 may rotate about the first and second rotation axes X1 and X2, respectively. In an embodiment, the rotation of the first and second shafts HS1 and HS2 may **bias the** first hinge cam 326 toward the second hinge cam 327 (e.g., in direction ②) via the first cam structure 3243 of the first arm 324 and the third cam structure 3253 of the second arm 325. In this case, the first hinge cam 326 may possess a repulsive force pushing it in the opposite direction (e.g., in direction ①) due to the repulsive force generated by the first magnet M1 and the second magnet M2. Similarly, when the first and second arms 324 and 325) rotate, the first and second shafts HS1 and HS2 may also rotate together. In an embodiment, the rotation of the first and second shafts HS1 and HS2 may bias the second hinge cam 327 toward the first hinge cam 326 (e.g., in direction ①) via the second cam structure 3244 of the first arm 324 and the fourth cam structure 3254 of the second arm 325. In this case, the second hinge cam 327 may possess a repulsive force pushing it in the opposite direction (e.g., in direction ②) due to the repulsive force generated by the first magnet M1 and the second magnet M2. Therefore, the first housing 210 and the second housing 220 may receive a predetermined torque during folding and unfolding operations or a rotational force for automatic rotation in the folding or unfolding direction when operating beyond a predetermined angle through the biasing force applied to the first and second hinge cams 326 and 327, which are biased toward the first and second arms (e.g., in direction ② and direction ①), via the first and second arms 324 and 325 and the first and second magnets M1 and M2 in the first and second cam accommodation spaces 3245 and 3255.

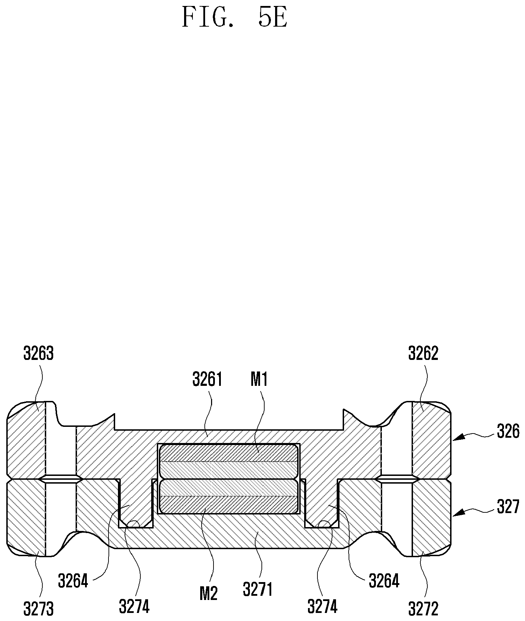

FIG. 5D is a perspective view of hinge cams according to various embodiments of the disclosure. FIG. 5E is a partial cross-sectional view illustrating a state in which the hinge cams according to various embodiments of the disclosure are facing each other.

Referring to FIGS. 5D and 5E, the first hinge cam 326 may include at least one guide protrusion 3264 protruding from the first cam body 3261 toward the second hinge cam 327. In an embodiment, the second hinge cam 327 may include at least one guide groove 3274 formed in the second cam body 3271 and configured to accommodate at least a portion of the at least one guide protrusion 3264. In an embodiment, the distance between the first hinge cam 326 and the second hinge cam 327 may vary within the range where a repulsive force is exerted therebetween by the first magnet M1 and the second magnet M2, depending on the folding operation of the first housing (e.g., the first housing 210 in FIG. 1A) and the second housing (e.g., the second housing 220 in FIG. 1A). In an embodiment, in such a case, by being guided in the state of being seated within the guide groove 3274, the guide protrusion 3264 may be used as alignment means to reduce misalignment between the first hinge cam 326 and the second hinge cam 327 during the variation in the distance therebetween, thereby contributing to ensuring the operational reliability of the hinge device 320.

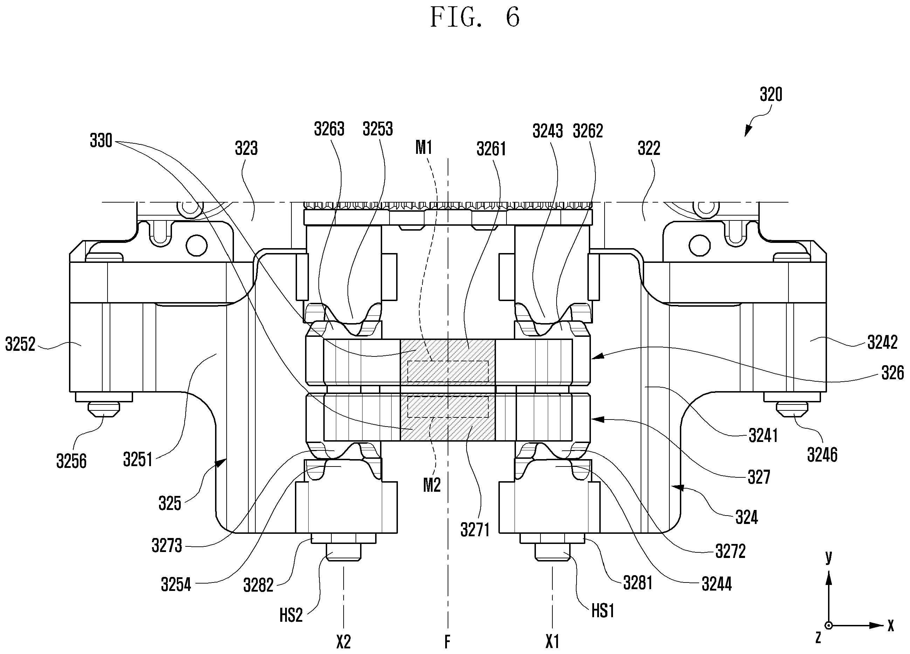

FIG. 6 is a view illustrating the configuration of a portion of a hinge device including a shielding member according to various embodiments of the disclosure.

In describing the hinge device 320 of FIG. 6, the same components as those of the hinge device 320 of FIG. 4 are denoted by the same reference numerals, and a detailed description thereof may be omitted.

Referring to FIG. 6, the hinge device 320 may be disposed in close proximity to the rear surface of a flexible display (e.g., the first display 230 in FIG. 1A) (e.g., a flexible display). In this case, the magnetic force of the first and second magnets M1 and M2, which are arranged between the first hinge cam 326 and the second hinge cam 327 to have a repulsive force, may affect the flexible display 230. To reduce this phenomenon, the hinge device 320 may include shielding members 330 disposed on the first cam body 3261 and the second cam body 3271, respectively, to shield the magnetic force. In an embodiment, the shielding members 330 may have a size that overlaps at least the first magnet M1 and the second magnet M2 when viewed from above the flexible display 230. In an embodiment, the shielding members 330 may be disposed on the first cam body 3261 and the second cam body 3271 at the closest positions to the rear surface of the flexible display 230. In some embodiments, when the hinge device 320 further includes additional shielding members disposed on the first and second cam bodies 3261, 3271 at the positions farthest from the flexible display 230, the external influence of the magnetic force of the first and second magnets M1 and M2 on the rear surface of the electronic device (e.g., the electronic device 200 in FIG. 1A) may be reduced.

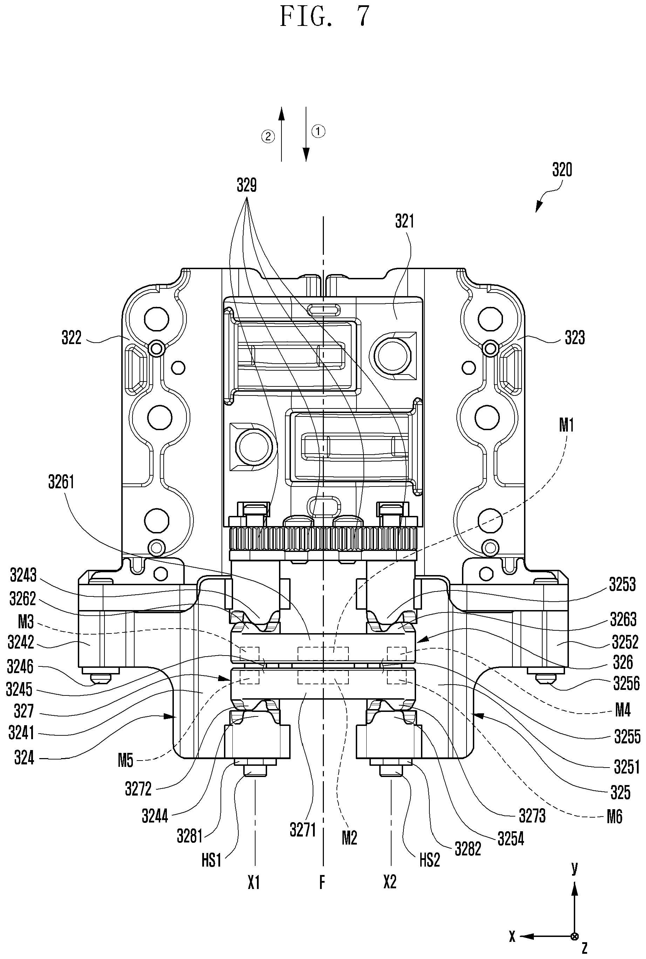

FIG. 7 is a view illustrating the configuration of a hinge device according to various embodiments of the disclosure.

In describing the hinge device 320 of FIG. 7, the same components as those of the hinge device 320 of FIG. 5B are denoted by the same reference numerals, and a detailed description thereof may be omitted.

Referring to FIG. 7, the hinge device 320 may include a first magnet M1 disposed on the first hinge cam 326 and a second magnet M2 disposed on the second hinge cam 327 and configured to have a repulsive force against the magnetic force the first magnet M1. In an embodiment, the repulsive force between the first magnet M1 on the first cam body 3261 of the first hinge cam 326 and the second magnet M2 on the second cam body 3271 of the second hinge cam 327 alone may be insufficient to apply enough biasing force to push the first hinge cam 326 and the second hinge cam 327 away from each other. In an embodiment, the hinge device 320 may include a third magnet M3 and a fourth magnet M4 disposed on the left and right sides of the first magnet M1 on the first cam body 3261 of the first hinge cam 326, and a fifth magnet M5 and a sixth magnet M6 disposed on the left and right sides of the second magnet M2 on the second cam body 3271 of the second hinge cam 327. In an embodiment, the third magnet M3 may be arranged to face the fifth magnet M5 with the same polarity. In an embodiment, the fourth magnet M4 may be arranged to face the fifth magnet M6 with the same polarity. Accordingly, the first hinge cam 326 and the second hinge cam 327 may be supported not only by the repulsive force between the first magnet M1 and the second magnet M2 but also by the repulsive force between the third magnet M3 and the fifth magnet M5 and the repulsive force between the fourth magnet M4 and the sixth magnet M6, thereby contributing to improving the operational reliability of the hinge device 320.

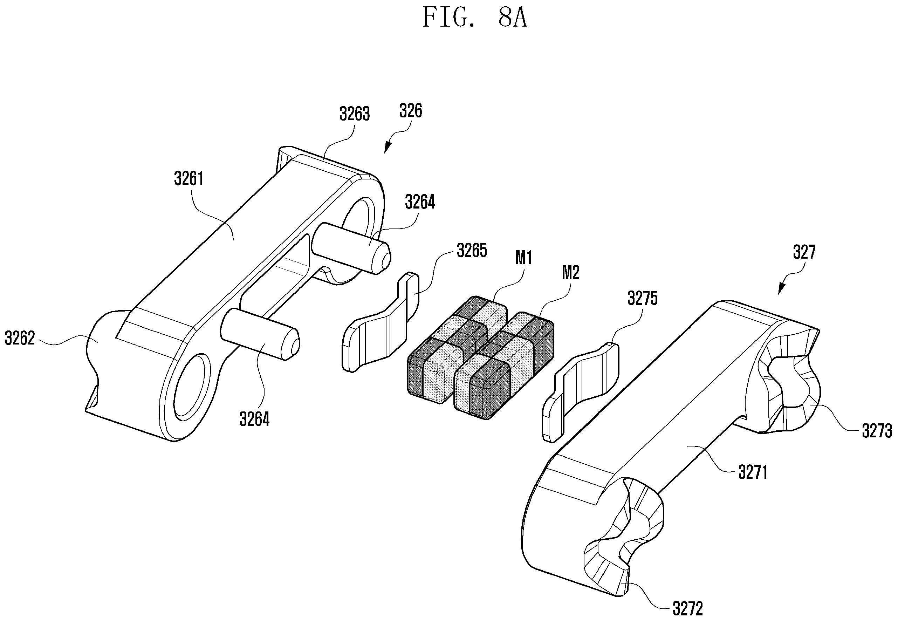

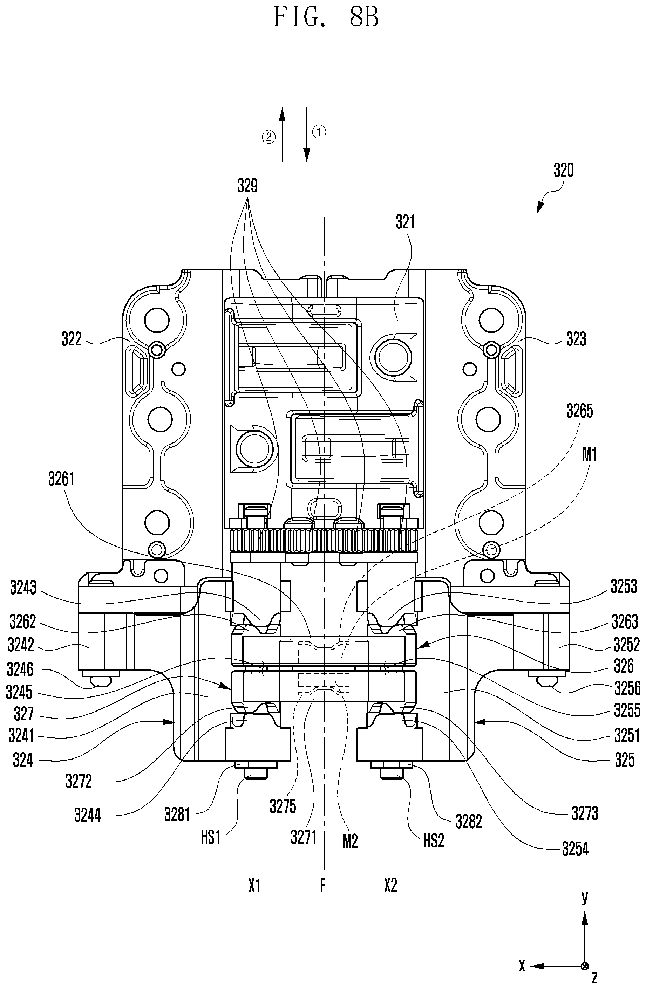

**FIG.** 8A is an exploded perspective view illustrating a state in which a pair of springs are applied between hinge cams according to various embodiments of the disclosure. FIG. 8B is a view illustrating the configuration of the hinge device to which the pair of springs illustrated in FIG. 8A are applied, according to various embodiments of the disclosure.

In describing the hinge device 320 of FIG. 8B, the same components as those of the hinge device 320 of FIG. 5B are denoted by the same reference numerals, and a detailed description thereof may be omitted.

Referring to FIGS. 8A and 8B, the hinge device 320 may include a first magnet M1 disposed on the first hinge cam 326 and a second magnet M2 disposed on the second hinge cam 327 and configured to have a repulsive force against the magnetic force the first magnet M1. In an embodiment, the distance between the first hinge cam 326 and the second hinge cam 327 may be variable depending on the cam-linkage operation of cam structures caused by the folding operation of the electronic device (e.g., the electronic device 200 in FIG. 1A). This variable distance between the first and second hinge cams 326 and 327 may adjust the distance between the first and second magnets M1 and M2, thereby changing the intensity of the repulsive force and reducing the biasing force (e.g., the repulsive force).

According to an exemplary embodiment of the disclosure, the hinge device 320 may include a first spring 3265 disposed between the first cam body 3261 and the first magnet M1 on the first hinge cam 326 and configured to bias the first magnet M1 toward the second hinge cam 327 (e.g., in direction ②). In an embodiment of the disclosure, the hinge device 320 may include a second spring 3275 disposed between the second cam body 3271 and the second magnet M2 on the first hinge cam 327 and configured to bias the second magnet M2 toward the first hinge cam 326 (e.g., in direction ①). In an embodiment, the first and second springs 3265 and 3275 may be leaf springs with relatively expanded contact areas with the magnets M1 and M2 to reduce unbalanced behavior and damage to the magnets M1 and M2 when the electronic device 200 is subjected to external impact. In an embodiment, even when the distance between the first and second hinge cams 326 and 327 increases due to the folding operation of the electronic device 200, the distance between the first and second magnets M1 and M2 may be relatively less increased or maintained constant through the first and second springs 3265 and 3275, ensuring the operation reliability of the hinge device 320 by maintaining a uniform repulsive force.

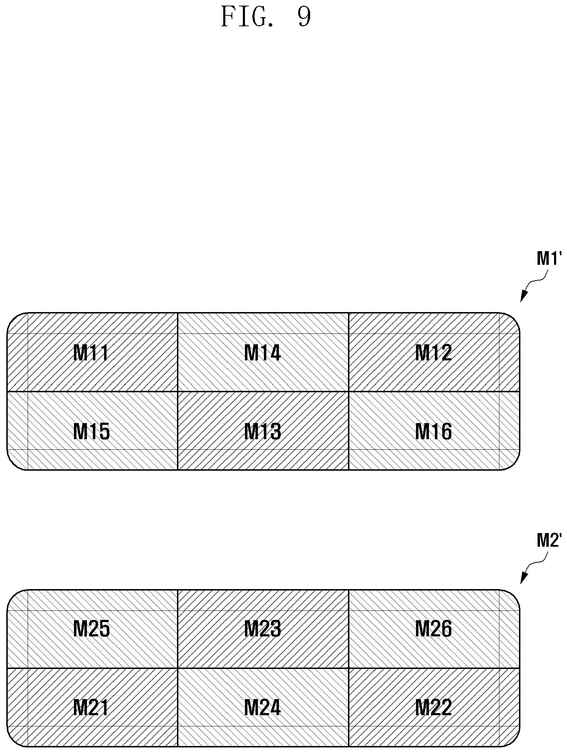

FIG. 9 is a view illustrating the arrangement structures of magnets according to various embodiments of the disclosure.

Referring to FIG. 9, first and second magnets M1 and M2 applied to the first hinge cam 326 and the second hinge cam 327 of the hinge device 320 of FIG. 5B may be replaced with the first and second magnet assemblies M1' and M2'. In an embodiment, the first magnet assembly M1' may be formed by bonding or coupling multiple first unit magnets M11, M12, M13, M14, M15, and M16 to one another. In an embodiment, the second magnet assembly M2' may be formed by bonding or coupling multiple first unit magnets M21, M22, M23, M24, M25, and M26 to one another. In an embodiment, the first magnet assembly M1' and the second magnet assembly M2' may be arranged such that the polarities of the unit magnets (e.g., the multiple first unit magnets M11, M12, M13, M14, M15, and M16 or the multiple second unit magnets M21, M22, M23, M24, M25, and M26 alternate, thereby increasing the repulsive force (e.g., repulsion) therebetween according to the principle of the Halbach array. For example, the multiple first unit magnets M11, M12, M13, M14, M15, and M16 of the first magnet assembly M1' and the multiple second unit magnets M21, M22, M23, M24, M25, and M26 of the second magnet assembly M2' corresponding thereto may be arranged such that the same polarities face each other.

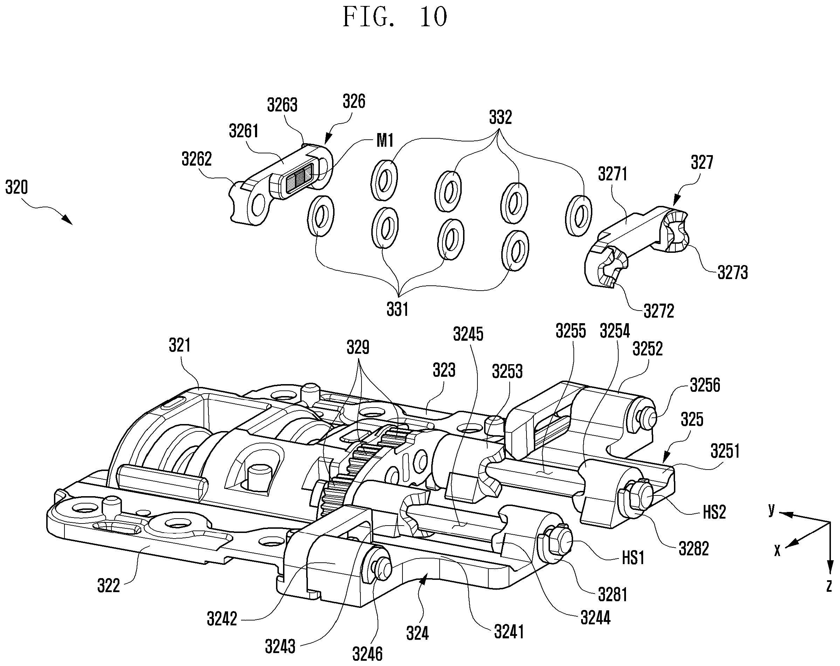

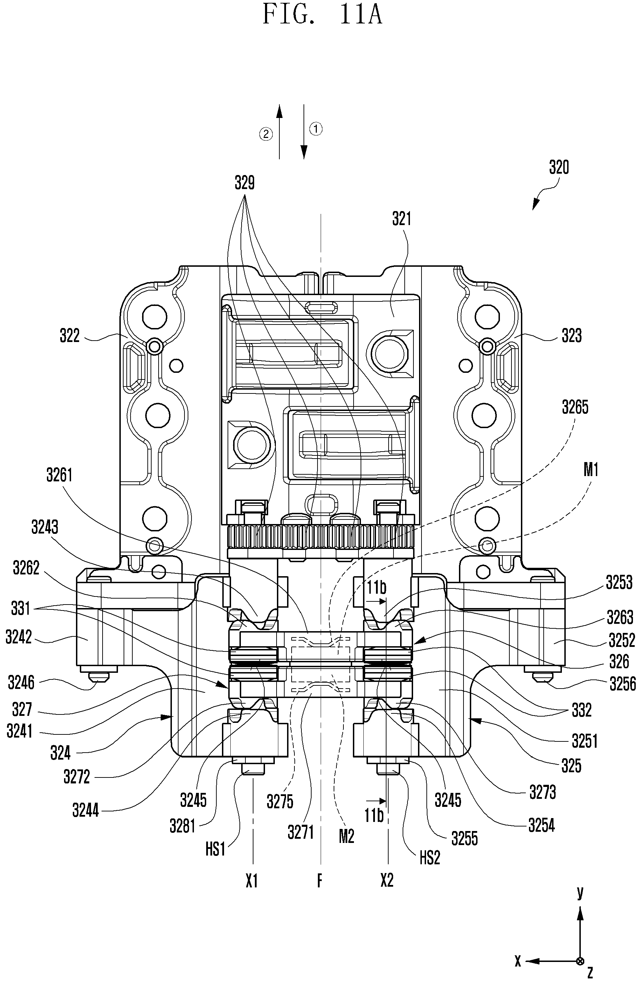

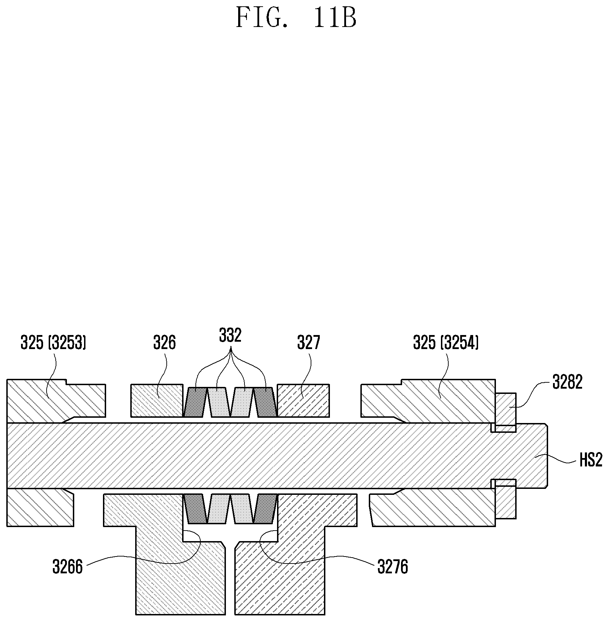

FIG. 10 is an exploded perspective view of a hinge device in which a pair of springs are applied according to various embodiments of the disclosure. FIG. 11A is a view illustrating the configuration of the hinge device to which the pair of springs illustrated in FIG. 10 are applied, according to various embodiments of the disclosure. FIG. 11B is a partial cross-sectional view of the electronic device according to various embodiments of the disclosure taken along line 11b-11b in FIG. 11A.

In describing the electronic device of FIGS. 10 to 11B, the same reference numerals are denoted to components substantially the same as those of the electronic device of FIG. 8B, and a detailed description thereof may be omitted.

Referring to FIGS. 10 to 11B, the hinge device 320 may include a first magnet M1 disposed on the first hinge cam 326 and a second magnet M2 disposed on the second hinge cam 327 and configured to have a repulsive force against the magnetic force the first magnet M1. In an embodiment, the repulsive force between the first magnet M1 on the first cam body 3261 of the first hinge cam 326 and the second magnet M2 on the second cam body 3271 of the second hinge cam 327 alone may be insufficient to apply enough biasing force to push the first hinge cam 326 and the second hinge cam 327 away from each other. In some embodiments, even if a first spring 3265 biasing the first magnet M1 and a second spring 3275 biasing the second magnet M2 are additionally provided, the biasing force (e.g., repulsive force) pushing the first hinge cam 326 and the second hinge cam 327 away from each other may still be insufficient.

According to an exemplary embodiment of the disclosure, the hinge device 320 may include a first spring assembly 331 and a second spring assembly 332 disposed between the first hinge cam 326 and the second hinge cam 327 and configured to bias the first hinge cam 326 and the second hinge cam 327 in opposite directions. In an embodiment, the first spring assembly 331 may be arranged in such a way that the first shaft HS1 passes therethrough, and may include washer springs (e.g., disc springs) that bias the first cam body 3261 and the second cam body 3271 in opposite directions. In an embodiment, the second spring assembly 332 may be arranged in such a way that the second shaft HS2 passes therethrough, and may include washer springs (e.g., disc springs) that bias the first cam body 3261 and the second cam body 3271 in opposite directions. In an embodiment, the spring assemblies 331 and 332 may be arranged to be at least partially seated in recesses 3266 and 3276 formed at corresponding positions on the first hinge cam 326 and the second hinge cam 327. In an embodiment, the first and second spring assemblies 331 and 332 may be replaced with compression coil springs configured in such a way that the first and second shafts HS1 and HS2 pass therethrough and bias the first and second hinge cams 326 and 327 in opposite directions.

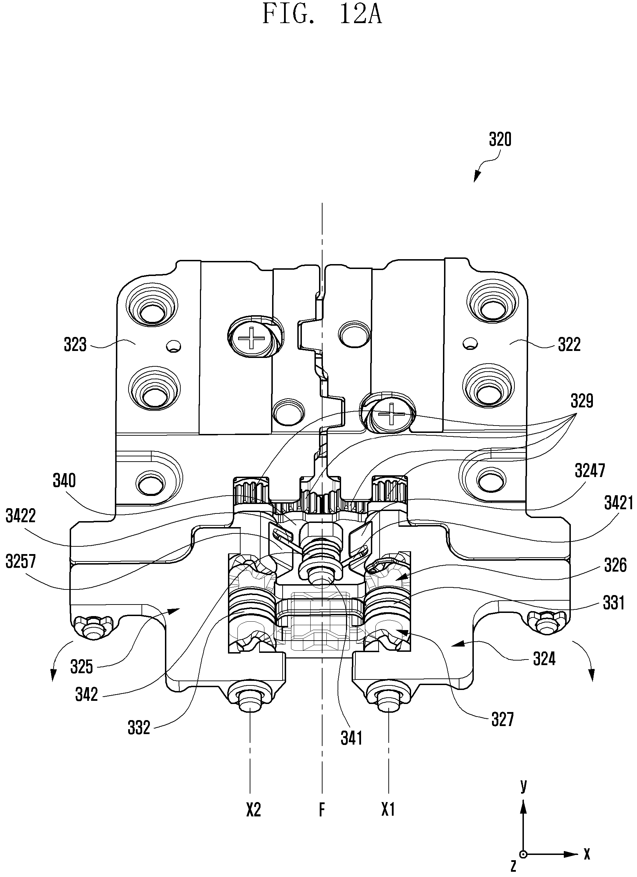

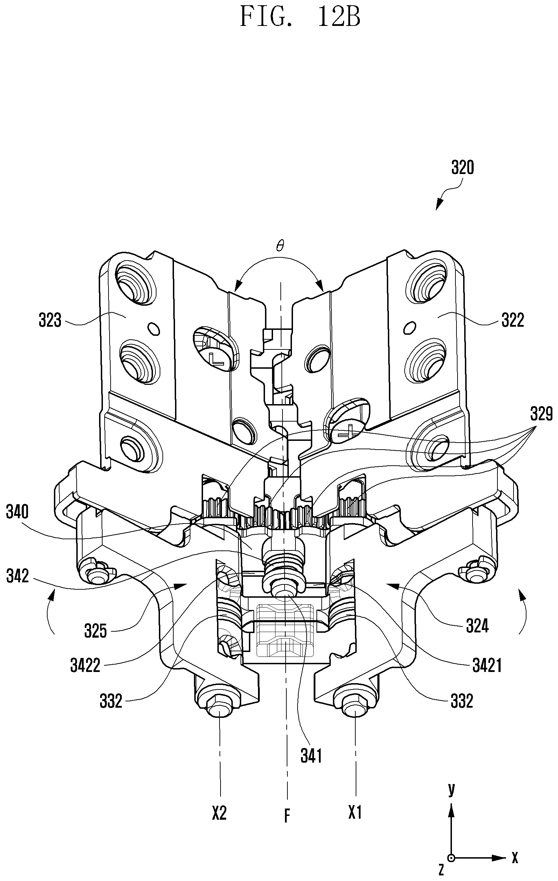

FIGS. 12A and 12B are perspective views of a hinge device with a detent structure according to various embodiments of the disclosure.

In describing the hinge device 320 illustrated in FIGS. 12A and 12B, the same reference numerals are denoted for components substantially the same as those of the hinge device 320 in FIG. 4B, and detailed descriptions thereof may be omitted.

Referring to FIGS. 12A and 12B, the hinge device 320 may include a detent structure configured to provide a continuous biasing force in the unfolding direction at a predetermined angle θ (e.g., when the angle between the unfolded state and the folding state is about 20 degrees or less) as the electronic device (e.g., the electronic device 200 in FIG. 1A) transitions from the folded state to the unfolded state. In an embodiment, the detent structure may include a torsion spring 342 fixed along the folding axis F, with one end 3421 configured to selectively bias a portion of the first arm 324 in the unfolding direction depending on the folding angle, and the other end 3422 configured to selectively bias a portion of the second arm 325 in the unfolding direction depending on the folding angle. In an embodiment, the torsion spring 342 may be fixed to the support shaft 341 protruding from the gear support piece 340 arranged to support the gear assembly 329. In an embodiment, the center of the torsion spring 342 may be fixed to the support shaft 341 in such a way that the support shaft 341 passes therethrough, one end 3421 thereof is selectively engaged with a first engagement portion 3247 extending from the first arm 324, and the other end 3422 is selectively engaged with a second engagement portion 3257 extending from the second arm 325. In an embodiment, when the first rotator 322 and the second rotator 323 are folded beyond a predetermined angle θ (e.g., about 20 degrees) from the fully unfolded state, the first end 3421 and the second end 3422 of the torsion spring 342 may maintain the state in which the first engagement portion 3247 and the second engagement portion 3257 are separated from each other. In one embodiment, when the first rotator 322 and the second rotator 323 are folded to a predetermined angle θ (e.g., about 20 degrees) or less from the fully unfolded state, the first end 3421 and the second end 3422 of the torsion spring 342 may be in contact with the first engagement portion 3247 and the second engagement portion 3257 to bias the electronic device 200 in the unfolding direction.

According to an exemplary embodiment of the disclosure, when the first rotator 322 and the second rotator 323 are folded to a predetermined angle θ (e.g., about 20 degrees) or less from the fully unfolded state, the torsion spring 342 may provide a continuous biasing force in the unfolding direction, thereby contributing to the improvement of the operation reliability of the electronic device 200.

Although not illustrated, the hinge device 320 according to exemplary embodiments of the disclosure may include a single hinge cam and a cam coupling structure of the first arm 324 and the second arm 325, coupled to the hinge cam. For example, when only the first hinge cam 326 is provided, the second hinge cam 327 may be replaced with a support structure (e.g., a support bracket) disposed on the rotator bracket 321. In such a case, the first magnet M1 may be disposed on the first hinge cam 326, and the second magnet M2 may be disposed on the support structure at a position where a repulsive force reacts with the first magnet M1.

According to various embodiments, an electronic device (e.g., the electronic device 200 in FIG. 3) may include a first housing (e.g., the first housing 210 in FIG. 3), a second housing (e.g., the second housing 220 in FIG. 3), and at least one hinge device (e.g., the hinge device 320 in FIG. 4) that connects the first housing and the second housing to be rotatable relative to each other around a folding axis (e.g., the folding axis F in FIG. 4). The at least one hinge device may include a first arm (e.g., the first arm 324 in FIG. 4) connected to the first housing and arranged to be rotatable around a first rotation axis (e.g., the first rotation axis X1 in FIG. 4) parallel to the folding axis, the first arm including first and second cam structures (e.g., the first cam structure 3243 and the second cam structure 3244 in FIG. 4) spaced apart from each other to define a first cam accommodation space (e.g., the first cam accommodation space 3245 in FIG. 4), a second arm (e.g., the second arm 325 in FIG. 4) connected to the second housing and arranged to be rotatable around a second rotation axis (e.g., the second rotation axis X2 in FIG. 4) parallel to the folding axis, the second arm including third and fourth cam structures (e.g., the third cam structure 3253 in FIG. 4) spaced apart from each other to define a second cam accommodation space (e.g., the second cam accommodation space 3255 in FIG. 4), a first hinge cam (e.g., the first hinge cam 326 in FIG. 4) arranged to be movable in a direction parallel to the folding axis, the first hinge cam including fifth and sixth cam structures (e.g., the fifth cam structure 3262 and the sixth cam structure 3263 in FIG. 4) cam-coupled with the first and third cam structures, respectively, in the first and second cam accommodation spaces, a second hinge cam (e.g., the second hinge cam 327 in FIG. 4) disposed adjacent to the first hinge cam and arranged to be movable in a direction parallel to the folding axis, the second hinge cam including seventh and eighth cam structures (e.g., the seventh cam structure 3272 and the eighth cam structure 3273 in FIG. 4) cam-coupled with the second and fourth cam structures, respectively, in the first and second cam accommodation spaces, a first magnet (e.g., the first magnet M1 in FIG. 4) arranged on the first hinge cam, and a second magnet (e.g., the second magnet M2 in FIG. 4) arranged on the second hinge cam to react with the magnetic force of the first magnet.

According to various embodiments, the first magnet and the second magnet are arranged to exert a repulsive force against each other.

According to various embodiments, the first hinge cam (e.g., the hinge cam 326 in FIG. 4) may include a first cam body (e.g., the first cam body 3261 in FIG. 4), a fifth cam structure (e.g., the fifth cam structure 3262 in FIG. 4) extending from the first cam body and into the first cam accommodation space, and a sixth cam structure (e.g., the sixth cam structure 3263 in FIG. 4) extending from the first cam body and into the second cam accommodation space. The first magnet may be disposed on the first cam body.

According to various embodiments, the second hinge cam (e.g., the second hinge cam 327 in FIG. 4) may include a second cam body (e.g., the second cam body 3271 in FIG. 4), a seventh cam structure (e.g., the seventh cam structure 3272 in FIG. 4) extending from the second cam body and into the first cam accommodation space, and an eighth cam structure (e.g., the eighth cam structure 3273 in FIG. 4) extending from the second cam body and into the second cam accommodation space. The second magnet may be disposed on the first cam body to react with the magnetic force of the first magnet.

According to various embodiments, the electronic device may include a first shaft (e.g., the first shaft HS1 in FIG. 4) disposed on one side of the folding axis along the first rotation axis parallel to the folding axis. The first arm, the first hinge cam, and the second hinge cam may be coupled by the first shaft penetrating through the first cam structure, the second cam structure, the fifth cam structure, and the seventh cam structure. The first arm may be coupled to rotate together with the first shaft, while the first hinge cam and the second hinge cam may be coupled to idle with respect to the first shaft.

According to various embodiments, the electronic device may include a second shaft (e.g., the second shaft HS2 in FIG. 4) disposed on one side of the folding axis along the second rotation axis parallel to the folding axis. The second arm, the first hinge cam, and the second hinge cam may be coupled by the second shaft penetrating through the third cam structure, the fourth cam structure, the sixth cam structure, and the eighth cam structure. The second arm may be coupled to rotate together with the second shaft, while the first hinge cam and the second hinge cam may be coupled to idle with respect to the second shaft.

According to various embodiments, the electronic device may include a first rotator (e.g., the first rotator 322 in FIG. 4) having a portion coupled to the first housing and another portion pivotally coupled to the first arm, and a second rotator (e.g., the second rotator 323 in FIG. 4) having a portion coupled to the second housing and another portion pivotally coupled to the second arm.

According to various embodiments, the electronic device may include a first spring (e.g., the first spring 3265 in FIG. 8A) disposed between the first hinge cam and the first magnet to bias the first magnet toward the second hinge cam, and a second spring (e.g., the second spring 3275 in FIG. 8A) disposed between the second hinge cam and the second magnet to bias the second magnet toward the first hinge cam.

According to various embodiments, the first spring and the second spring may each include a leaf spring.

According to various embodiments, the electronic device may include a flexible display (e.g., the display 230 in FIG. 3) disposed to be supported by the first housing and the second housing, and shielding members (e.g., the shielding members 330 in FIG. 6) disposed on the first hinge cam and the second hinge cam, respectively, between the flexible display and the first hinge cam, and between the flexible display and the second hinge cam.

According to various embodiments, the shielding members may have sizes that overlap at least the first magnet and the second magnet, respectively, when viewed from above the flexible display.

According to various embodiments, the electronic device may include a first spring assembly (e.g., the first spring assembly 331 in FIG. 10) disposed in the first cam accommodation space along the first rotation axis, and a second spring assembly (e.g., the second spring assembly 332 in FIG. 10) disposed in the second cam accommodation space along the second rotation axis. The first spring assembly and the second spring assembly may be arranged to apply in a direction in which the first hinge cam and the second hinge cam are pushed away from each other.

According to various embodiments, the first spring assembly and the second spring assembly may each include multiple washer springs.

According to various embodiments, the electronic device may include at least one guide protrusion (e.g., the guide protrusion 3264 in FIG. 5E) protruding from the first hinge cam toward the second hinge cam, and at least one guide groove (e.g., the guide groove 3274 in FIG. 5E) provided in the second hinge cam. The at least one guide protrusion may be at least partially accommodated in the at least one guide groove when the first hinge cam moves relative to the second hinge cam.

According to various embodiments, the electronic device may include a torsion spring (e.g., the torsion spring 342 in FIG. 12A) installed along the folding axis and arranged such that one end thereof selectively biases at least a portion of the first arm in a rotating direction, and the other end thereof selectively biases at least a portion of the second arm in a rotating direction.

According to various embodiments, the torsion spring may be arranged to continuously bias the first housing and the second housing in an unfolding direction by coming into contact with the first arm and the second arm when the electronic device is folded to a predetermined angle or less from an unfolded state.

According to various embodiments, the torsion spring may be arranged to maintain a spaced state from the first arm and the second arm when the electronic device is folded a predetermined angle or more from the unfolded state.

According to various embodiments, an electronic device may include a first housing (e.g., the first housing 210 in FIG. 3), a second housing (e.g., the second housing 220 in FIG. 3), at least one hinge assembly (e.g., the hinge assembly 320 in FIG. 4) connecting the first housing and the second housing to be rotatable with respect to each other around a folding axis (e.g., the folding axis F in FIG. 4), and a flexible display (e.g., the flexible display 230 in FIG. 3) disposed to be supported by the first housing and the second housing. The at least one hinge device may include a first arm (e.g., the first arm 324 in FIG. 4) connected to the first housing and arranged to be rotatable around a first rotation axis (e.g., the first rotation axis X1 in FIG. 4) parallel to the folding axis, the first arm including a first cam structure (e.g., the first cam structure 3243 in FIG. 4), a second arm (e.g., the second arm 325 in FIG. 4) connected to the second housing and arranged to be rotatable around a second rotation axis (e.g., the second rotation axis X2 in FIG. 4) parallel to the folding axis, the second arm including a second cam structure (e.g., the second cam structure 3244 in FIG. 4), a hinge cam (e.g., the first hinge cam 326 in FIG. 4) arranged to be movable in a direction parallel to the folding axis, the hinge cam including third and fourth cam structures (e.g., the third and fourth cam structures 3253 and 3254 in FIG. 4) cam-coupled with the first and second cam structures, respectively, a support structure (e.g., rotator bracket 321 in FIG. 4) disposed adjacent to the hinge cam, a first magnet (e.g., the first magnet M1 in FIG. 4) arranged on the hinge cam, and a second magnet (e.g., the second magnet M2 of FIG. 4) arranged on the support structure to react with the magnetic force of the first magnet.

According to various embodiments, the first magnet and the second magnet are arranged to exert a repulsive force against each other.

According to various embodiments, a hinge device (e.g., the hinge device 320 in FIG. 4), which foldably connects a first housing (e.g., the first housing 210 in FIG. 3) and a second housing (e.g., the second housing 220 in FIG. 3), may include a first arm (e.g., the first arm 324 in FIG. 4) connected to the first housing and arranged to be rotatable around a first rotation axis (e.g., the first rotation axis X1 in FIG. 4) parallel to the folding axis, the first arm including first and second cam structures (e.g., the first cam structure 3243 and the second cam structure 3244 in FIG. 4) to define a first cam accommodation space (e.g., the first cam accommodation space 3245 in FIG. 4), a second arm (e.g., the second arm 325 in FIG. 4) connected to the second housing and arranged to be rotatable around a second rotation axis (e.g., the second rotation axis X2 in FIG. 4) parallel to the folding axis, the second arm including third and fourth cam structures (e.g., the third cam structure 3253 in FIG. 4) to define a second cam accommodation space (e.g., the second cam accommodation space 3255 in FIG. 4), a first hinge cam (e.g., the first hinge cam 326 in FIG. 4) arranged to be movable in a direction parallel to the folding axis, the first hinge cam including fifth and sixth cam structures (e.g., the fifth cam structure 3262 and the sixth cam structure 3263 in FIG. 4) cam-coupled with the first and third cam structures, respectively, in the first and second cam accommodation spaces, a second hinge cam (e.g., the second hinge cam 327 in FIG. 4) disposed adjacent to the first hinge cam and arranged to be movable in a direction parallel to the folding axis, the second hinge cam including seventh and eighth cam structures (e.g., the seventh cam structure 3272 and the eighth cam structure 3273 in FIG. 4) cam-coupled with the second and fourth cam structures, respectively, in the first and second cam accommodation spaces, a first magnet (e.g., the first magnet M1 in FIG. 4) arranged on the first hinge cam, and a second magnet (e.g., the second magnet M2 in FIG. 4) disposed at a position reacting to the magnetic force of the first magnet such that a repulsive force acts against the first magnet.

The embodiments of the disclosure disclosed in this specification and drawings are provided merely to propose specific examples in order to easily describe the technical features according to the embodiments of the disclosure and to help understanding of the embodiments of the disclosure, and are not intended to limit the scope of the embodiments of the disclosure. Accordingly, the scope of various embodiments of the disclosure is to be construed as including all changes or modifications derived based on the technical idea of the various embodiments of the disclosure in addition to the embodiments disclosed herein.

## Claims

1. An electronic device (200) comprising:
a first housing (210);
a second housing (220); and
at least one hinge assembly (320) connecting the first housing and the second housing to be rotatable relative to each other around a folding axis (F),
wherein the at least one hinge assembly comprises:
a first arm (324) connected to the first housing and arranged to be rotatable around a first rotation axis (X1) parallel to the folding axis, the first arm comprising first and second cam structures (3243, 3244) spaced apart from each other to define a first cam accommodation space (3245);
a second arm (325) connected to the second housing and arranged to be rotatable around a second rotation axis (X2) parallel to the folding axis, the second arm comprising third and fourth cam structures (3253, 3254) spaced apart from each other to define a second cam accommodation space (3255);
a first hinge cam (326) arranged to be movable in a direction parallel to the folding axis, the first hinge cam comprising fifth and sixth cam structures (3262, 3263) cam-coupled with the first and third cam structures, respectively, in the first and second cam accommodating spaces;
a second hinge cam (327) disposed adjacent to the first hinge cam and arranged to be movable in a direction parallel to the folding axis, the second hinge cam comprising seventh and eighth cam structures (3272, 3273) cam-coupled with the second and fourth cam structures, respectively, in the first and second cam accommodation spaces; and **characterised by**
a first magnet (M1) arranged on the first hinge cam; and
a second magnet (M2) arranged on the second hinge cam to react with a magnetic force of the first magnet.

2. The electronic device of claim 1, wherein the first magnet and the second magnet are arranged to exert a repulsive force against each other.

3. The electronic device of claim 1 or 2, wherein the first hinge cam (326) comprises:
a first cam body (3261);
the fifth cam structure (3262) extending from the first cam body into the first cam accommodation space; and
the sixth cam structure (3263) extending from the first cam body into the second cam accommodation space, and
wherein the first magnet is arranged on the first cam body.

4. The electronic device of claim 3, wherein the second hinge cam (327) comprises:
a second cam body (3271);
the seventh cam structure (3272) extending from the second cam body into the first cam accommodation space; and
the eighth cam structure (3273) extending from the second cam body into the second cam accommodation space, and
wherein the second magnet is arranged on the first cam body to react with the magnetic force of the first magnet.

5. The electronic device of one of claims 1 to 4, comprising:
a first shaft (HS1) arranged on one side of the folding axis along the first rotation axis parallel to the folding axis,
wherein the first arm, the first hinge cam, and the second hinge cam are coupled by the first shaft penetrating through the first cam structure, the second cam structure, the fifth cam structure, and the seventh cam structure, and
wherein the first arm is coupled to rotate together with the first shaft, and the first hinge cam and the second hinge cam are coupled to idle with respect to the first shaft.

6. The electronic device of claim 5, comprising:
a second shaft (HS2) arranged on one side of the folding axis along the second rotation axis parallel to the folding axis,
wherein the second arm, the first hinge cam, and the second hinge cam are coupled by the second shaft penetrating through the third cam structure, the fourth cam structure, the sixth cam structure, and the eighth cam structure, and
wherein the second arm is coupled to rotate together with the second shaft, and the first hinge cam and the second hinge cam are coupled to idle with respect to the second shaft.

7. The electronic device of one of claims 1 to 6, comprising:
a first rotator (322) having a portion coupled to the first housing and another portion pivotally coupled to the first arm; and
a second rotator (323) having a portion coupled to the second housing and another portion pivotally coupled to the second arm.

8. The electronic device of one of claims 1 to 7, comprising:
a first spring (3265) disposed between the first hinge cam and the first magnet to bias the first magnet toward the second hinge cam; and
a second spring (3275) disposed between the second hinge cam and the second magnet to bias the second magnet toward the first hinge cam.

9. The electronic device of one of claims 1 to 8, comprising:
a flexible display (230) disposed to be supported by the first housing and the second housing; and
shielding members (330) disposed on the first hinge cam and the second hinge cam, respectively, between the flexible display and the first hinge cam, and between the flexible display and the second hinge cam, respectively.

10. The electronic device of claim 9, wherein the shielding members have sizes that overlap at least the first magnet and the second magnet, respectively, when viewed from above the flexible display.

11. The electronic device of one of claims 1 to 10, comprising:
a first spring assembly (331) disposed in the first cam accommodation space along the first rotation axis; and
a second spring assembly (332) disposed in the second cam accommodation space along the second rotation axis,
wherein the first spring assembly and the second spring assembly are arranged to apply pressure in a direction in which the first hinge cam and the second hinge cam are pushed away from each other.

12. The electronic device of claim 11, wherein the first spring assembly and the second spring assembly each comprise multiple washer springs.

13. The electronic device of one of claims 1 to 12, comprising:
at least one guide protrusion (3264) protruding from the first hinge cam toward the second hinge cam; and
at least one guide groove (3274) provided in the second hinge cam,
wherein the at least one guide protrusion is at least partially accommodated in the at least one guide groove when the first hinge cam moves relative to the second hinge cam.

14. The electronic device of one of claims 1 to 13, comprising:
a torsion spring (342) installed along the folding axis and arranged such that one end thereof selectively biases at least a portion of the first arm in a rotating direction, and another end thereof selectively biases at least a portion of the second arm in a rotating direction.

15. The electronic device of claim 14, wherein the torsion spring is arranged to continuously bias the first housing and the second housing in an unfolding direction by coming into contact with the first arm and the second arm when the electronic device is folded to a predetermined angle or less from an unfolded state.

## Patentansprüche

1. Elektronische Vorrichtung (200), umfassend:
ein erstes Gehäuse (210);
ein zweites Gehäuse (220); und
mindestens eine Scharnieranordnung (320), die das erste Gehäuse und das zweite Gehäuse so verbindet, dass sie relativ zueinander um eine Faltachse (F) drehbar sind,
wobei die mindestens eine Scharnieranordnung Folgendes umfasst:
einen ersten Arm (324), der mit dem ersten Gehäuse verbunden und so angeordnet ist, dass er um eine erste Drehachse (X1) parallel zur Faltachse drehbar ist, wobei der erste Arm eine erste und eine zweite Nockenstruktur (3243, 3244) umfasst, die voneinander beabstandet sind, um einen ersten Nockenaufnahmeraum (3245) zu definieren;
einen zweiten Arm (325), der mit dem zweiten Gehäuse verbunden und so angeordnet ist, dass er um eine zweite Drehachse (X2) parallel zur Faltachse drehbar ist, wobei der zweite Arm eine dritte und eine vierte Nockenstruktur (3253, 3254) umfasst, die voneinander beabstandet sind, um einen zweiten Nockenaufnahmeraum (3255) zu definieren;
einen ersten Scharniernocken (326), der so angeordnet ist, dass er in einer Richtung parallel zur Faltachse bewegbar ist, wobei der erste Scharniernocken eine fünfte und eine sechste Nockenstruktur (3262, 3263) umfasst, die jeweils mit der ersten bzw. der dritten Nockenstruktur in dem ersten bzw. dem zweiten Nockenaufnahmeraum nockengekoppelt sind;
einen zweiten Scharniernocken (327), der an den ersten Scharniernocken angrenzt und so angeordnet ist, dass er in einer Richtung parallel zur Faltachse bewegbar ist, wobei der zweite Scharniernocken eine siebte und eine achte Nockenstruktur (3272, 3273) umfasst, die jeweils mit der zweiten bzw. der vierten Nockenstruktur in dem ersten bzw. dem zweiten Nockenaufnahmeraum nockengekoppelt sind; und **gekennzeichnet durch**
einen ersten Magneten (M1), der auf dem ersten Scharniernocken angeordnet ist; und
einen zweiten Magneten (M2), der auf dem zweiten Scharniernocken angeordnet ist, um mit einer Magnetkraft des ersten Magneten zu reagieren.

2. Elektronische Vorrichtung nach Anspruch 1, wobei der erste Magnet und der zweite Magnet so angeordnet sind, dass sie eine abstoßende Kraft aufeinander ausüben.

3. Elektronische Vorrichtung nach Anspruch 1 oder 2, wobei der erste Scharniernocken (326) Folgendes umfasst:
einen ersten Nockenkörper (3261);
die fünfte Nockenstruktur (3262), die sich vom ersten Nockenkörper in den ersten Nockenaufnahmeraum erstreckt; und
die sechste Nockenstruktur (3263), die sich vom ersten Nockenkörper in den zweiten Nockenaufnahmeraum erstreckt, und
wobei der erste Magnet auf dem ersten Nockenkörper angeordnet ist.

4. Elektronische Vorrichtung nach Anspruch 3, wobei der zweite Scharniernocken (327) Folgendes umfasst:
einen zweiten Nockenkörper (3271);
die siebte Nockenstruktur (3272), die sich vom zweiten Nockenkörper in den ersten Nockenaufnahmeraum erstreckt; und
die achte Nockenstruktur (3273), die sich vom zweiten Nockenkörper in den zweiten Nockenaufnahmeraum erstreckt, und
wobei der zweite Magnet auf dem ersten Nockenkörper angeordnet ist, um mit der Magnetkraft des ersten Magneten zu reagieren.

5. Elektronische Vorrichtung nach einem der Ansprüche 1 bis 4, umfassend:
eine erste Welle (HS1), die auf einer Seite der Faltachse entlang der ersten Drehachse parallel zur Faltachse angeordnet ist,
wobei der erste Arm, der erste Scharniernocken und der zweite Scharniernocken durch die erste Welle gekoppelt sind, die durch die erste Nockenstruktur, die zweite Nockenstruktur, die fünfte Nockenstruktur und die siebte Nockenstruktur hindurchragt, und
wobei der erste Arm so gekoppelt ist, dass er sich gemeinsam mit der ersten Welle dreht, während der erste Scharniernocken und der zweite Scharniernocken so gekoppelt sind, dass sie in Bezug auf die erste Welle leerlaufen.

6. Elektronische Vorrichtung nach Anspruch 5, umfassend:
eine zweite Welle (HS2), die auf einer Seite der Faltachse entlang der zweiten Drehachse parallel zur Faltachse angeordnet ist,
wobei der zweite Arm, der erste Scharniernocken und der zweite Scharniernocken durch die zweite Welle gekoppelt sind, die durch die dritte Nockenstruktur, die vierte Nockenstruktur, die sechste Nockenstruktur und die achte Nockenstruktur hindurchragt, und
wobei der zweite Arm so gekoppelt ist, dass er sich gemeinsam mit der zweiten Welle dreht, während der erste Scharniernocken und der zweite Scharniernocken so gekoppelt sind, dass sie in Bezug auf die zweite Welle leerlaufen.

7. Elektronische Vorrichtung nach einem der Ansprüche 1 bis 6, umfassend:
einen ersten Rotator (322) mit einem Abschnitt, der mit dem ersten Gehäuse gekoppelt ist, und einem weiteren Abschnitt, der schwenkbar mit dem ersten Arm gekoppelt ist; und
einen zweiten Rotator (323) mit einem Abschnitt, der mit dem zweiten Gehäuse gekoppelt ist, und einem weiteren Abschnitt, der schwenkbar mit dem zweiten Arm gekoppelt ist.

8. Elektronische Vorrichtung nach einem der Ansprüche 1 bis 7, umfassend:
eine erste Feder (3265), die zwischen dem ersten Scharniernocken und dem ersten Magneten angeordnet ist, um den ersten Magneten in Richtung des zweiten Scharniernockens vorzuspannen; und
eine zweite Feder (3275), die zwischen dem zweiten Scharniernocken und dem zweiten Magneten angeordnet ist, um den zweiten Magneten in Richtung des ersten Scharniernockens vorzuspannen.

9. Elektronische Vorrichtung nach einem der Ansprüche 1 bis 8, umfassend:
eine flexible Anzeige (230), die so angeordnet ist, dass sie von dem ersten Gehäuse und dem zweiten Gehäuse gestützt wird; und
Abschirmelemente (330), die jeweils auf dem ersten Scharniernocken bzw. dem zweiten Scharniernocken angeordnet sind, und zwar jeweils zwischen der flexiblen Anzeige und dem ersten Scharniernocken bzw. zwischen der flexiblen Anzeige und dem zweiten Scharniernocken.

10. Elektronische Vorrichtung nach Anspruch 9, wobei die Abschirmelemente Abmessungen aufweisen, die, von oberhalb der flexiblen Anzeige betrachtet, jeweils zumindest den ersten Magneten und den zweiten Magneten überlappen.

11. Elektronische Vorrichtung nach einem der Ansprüche 1 bis 10, umfassend:
eine erste Federanordnung (331), die in dem ersten Nockenaufnahmeraum entlang der ersten Drehachse angeordnet ist; und
eine zweite Federanordnung (332), die in dem zweiten Nockenaufnahmeraum entlang der zweiten Drehachse angeordnet ist,
wobei die erste Federanordnung und die zweite Federanordnung so angeordnet sind, dass sie Druck in einer Richtung ausüben, in der der erste Scharniernocken und der zweite Scharniernocken voneinander weggedrückt werden.

12. Elektronische Vorrichtung nach Anspruch 11, wobei die erste Federanordnung und die zweite Federanordnung jeweils mehrere Tellerfedern umfassen.

13. Elektronische Vorrichtung nach einem der Ansprüche 1 bis 12, umfassend:
mindestens einen Führungsvorsprung (3264), der von dem ersten Scharniernocken in Richtung des zweiten Scharniernockens vorsteht; und
mindestens eine Führungsnut (3274), die in dem zweiten Scharniernocken vorgesehen ist,
wobei der mindestens eine Führungsvorsprung zumindest teilweise in der mindestens einen Führungsnut aufgenommen ist, wenn sich der erste Scharniernocken relativ zum zweiten Scharniernocken bewegt.

14. Elektronische Vorrichtung nach einem der Ansprüche 1 bis 13, umfassend:
eine Torsionsfeder (342), die entlang der Faltachse angebracht und so angeordnet ist, dass ein Ende davon zumindest einen Abschnitt des ersten Arms selektiv in eine Drehrichtung vorspannt und ein anderes Ende davon zumindest einen Abschnitt des zweiten Arms selektiv in eine Drehrichtung vorspannt.

15. Elektronische Vorrichtung nach Anspruch 14, wobei die Torsionsfeder so angeordnet ist, dass sie das erste Gehäuse und das zweite Gehäuse kontinuierlich in eine Entfaltungsrichtung vorspannt, indem sie mit dem ersten Arm und dem zweiten Arm in Kontakt kommt, wenn die elektronische Vorrichtung aus einem entfalteten Zustand auf einen vorbestimmten Winkel oder weniger gefaltet wird.

## Revendications

1. Dispositif électronique (200) comprenant :
un premier boîtier (210) ;
un second boîtier (220) ; et
au moins un ensemble charnière (320) reliant le premier boîtier et le second boîtier de manière à pouvoir tourner l'un par rapport à l'autre autour d'un axe de pliage (F),
dans lequel l'au moins un ensemble charnière comprend :
un premier bras (324) relié au premier boîtier et agencé pour pouvoir tourner autour d'un premier axe de rotation (X1) parallèle à l'axe de pliage, le premier bras comprenant des première et seconde structures de came (3243, 3244) espacées l'une de l'autre pour définir un premier espace de logement de came (3245) ;
un second bras (325) relié au second boîtier et agencé pour pouvoir tourner autour d'un second axe de rotation (X2) parallèle à l'axe de pliage, le second bras comprenant des troisième et quatrième structures de came (3253, 3254) espacées l'une de l'autre pour définir un second espace de logement de came (3255) ;
une première came de charnière (326) agencée pour être mobile dans une direction parallèle à l'axe de pliage, la première came de charnière comprenant des cinquième et sixième structures de came (3262, 3263) couplées par came aux première et troisième structures de came, respectivement, dans les premier et second espaces de logement de came ;
une seconde came de charnière (327) disposée de manière adjacente à la première came de charnière et agencée pour être mobile dans une direction parallèle à l'axe de pliage, la seconde came de charnière comprenant des septième et huitième structures de came (3272, 3273) couplées par came aux seconde et quatrième structures de came, respectivement, dans les premier et second espaces de logement de came ; et **caractérisé en ce que**
un premier aimant (M1) est agencé sur la première came de charnière ; et
un second aimant (M2) est agencé sur la seconde came de charnière pour réagir avec une force magnétique du premier aimant.

2. Dispositif électronique selon la revendication 1, dans lequel le premier aimant et le second aimant sont agencés pour exercer une force de répulsion l'un contre l'autre.

3. Dispositif électronique selon la revendication 1 ou 2, dans lequel la première came de charnière (326) comprend :
un premier corps de came (3261) ;
la cinquième structure de came (3262) s'étendant depuis le premier corps de came dans le premier espace de logement de came ; et
la sixième structure de came (3263) s'étendant depuis le premier corps de came dans le second espace de logement de came, et
dans lequel le premier aimant est agencé sur le premier corps de came.

4. Dispositif électronique selon la revendication 3, dans lequel la seconde came de charnière (327) comprend :
un second corps de came (3271) ;
la septième structure de came (3272) s'étendant depuis le second corps de came dans le premier espace de logement de came ; et
la huitième structure de came (3273) s'étendant depuis le second corps de came dans le second espace de logement de came, et
dans lequel le second aimant est agencé sur le premier corps de came pour réagir avec la force magnétique du premier aimant.

5. Dispositif électronique selon l'une des revendications 1 à 4, comprenant :
un premier arbre (HS1) agencé sur un côté de l'axe de pliage le long du premier axe de rotation parallèle à l'axe de pliage,
dans lequel le premier bras, la première came de charnière et la seconde came de charnière sont couplés par le premier arbre traversant la première structure de came, la seconde structure de came, la cinquième structure de came et la septième structure de came, et
dans lequel le premier bras est couplé pour tourner conjointement avec le premier arbre, et la première came de charnière et la seconde came de charnière sont couplées pour tourner librement par rapport au premier arbre.

6. Dispositif électronique selon la revendication 5, comprenant :
un second arbre (HS2) agencé sur un côté de l'axe de pliage le long du second axe de rotation parallèle à l'axe de pliage,
dans lequel le second bras, la première came de charnière et la seconde came de charnière sont couplés par le second arbre traversant la troisième structure de came, la quatrième structure de came, la sixième structure de came et la huitième structure de came, et
dans lequel le second bras est couplé pour tourner conjointement avec le second arbre, et la première came de charnière et la seconde came de charnière sont couplées pour tourner librement par rapport au second arbre.

7. Dispositif électronique selon l'une des revendications 1 à 6, comprenant :
un premier élément rotatif (322) ayant une partie couplée au premier boîtier et une autre partie couplée de manière pivotante au premier bras ; et
un second élément rotatif (323) ayant une partie couplée au second boîtier et une autre partie couplée de manière pivotante au second bras.

8. Dispositif électronique selon l'une des revendications 1 à 7, comprenant :
un premier ressort (3265) disposé entre la première came de charnière et le premier aimant pour solliciter le premier aimant vers la seconde came de charnière ; et
un second ressort (3275) disposé entre la seconde came de charnière et le second aimant pour solliciter le second aimant vers la première came de charnière.

9. Dispositif électronique selon l'une des revendications 1 à 8, comprenant :
un affichage flexible (230) disposé de manière à être supporté par le premier boîtier et le second boîtier ; et
des éléments de blindage (330) disposés sur la première came de charnière et la seconde came de charnière, respectivement, entre l'affichage flexible et la première came de charnière, et entre l'affichage flexible et la seconde came de charnière, respectivement.

10. Dispositif électronique selon la revendication 9, dans lequel les éléments de blindage ont des dimensions qui chevauchent au moins le premier aimant et le second aimant, respectivement, lorsqu'ils sont vus depuis le dessus de l'affichage flexible.

11. Dispositif électronique selon l'une des revendications 1 à 10, comprenant :
un premier ensemble ressort (331) disposé dans le premier espace de logement de came le long du premier axe de rotation ; et
un second ensemble ressort (332) disposé dans le second espace de logement de came le long du second axe de rotation,
dans lequel le premier ensemble ressort et le second ensemble ressort sont agencés pour appliquer une pression dans une direction dans laquelle la première came de charnière et la seconde came de charnière sont poussées à l'écart l'une de l'autre.

12. Dispositif électronique selon la revendication 11, dans lequel le premier ensemble ressort et le second ensemble ressort comprennent chacun plusieurs ressorts à rondelle.

13. Dispositif électronique selon l'une des revendications 1 à 12, comprenant :
au moins une saillie de guidage (3264) faisant saillie depuis la première came de charnière vers la seconde came de charnière ; et
au moins une rainure de guidage (3274) prévue dans la seconde came de charnière,
dans lequel l'au moins une saillie de guidage est au moins partiellement logée dans l'au moins une rainure de guidage lorsque la première came de charnière se déplace par rapport à la seconde came de charnière.

14. Dispositif électronique selon l'une des revendications 1 à 13, comprenant :
un ressort de torsion (342) installé le long de l'axe de pliage et agencé de telle sorte qu'une extrémité de celui-ci sollicite sélectivement au moins une partie du premier bras dans une direction de rotation, et qu'une autre extrémité de celui-ci sollicite sélectivement au moins une partie du second bras dans une direction de rotation.

15. Dispositif électronique selon la revendication 14, dans lequel le ressort de torsion est agencé pour solliciter en continu le premier boîtier et le second boîtier dans une direction de dépliage en venant en contact avec le premier bras et le second bras lorsque le dispositif électronique est plié jusqu'à un angle prédéterminé ou inférieur à partir d'un état déplié.
